# EUROPEAN PATENT APPLICATION

(11) **EP 4 832 461 A1**
(43) Date of publication of application: **28.10.2026**
(21) Application number: 25745499.1
(22) Date of filing: 03.01.2025
(51) Int. Cl.: H04M 1/02, H02K 7/07, H02K 7/116, H05K 1/14, H05K 5/00

(54) **ELECTRONIC DEVICE INCLUDING MOTOR STRUCTURE**

(30) Priority: 23.01.2024 KR 20240010534; 29.03.2024 KR 20240043796
(71) Applicant: Samsung Electronics Co., Ltd., Suwon-si, Gyeonggi-do 16677 (KR)
(72) Inventor: JEONG, Hoyoung, Suwon-si Gyeonggi-do 16677 (KR); KANG, Hyunggwang, Suwon-si Gyeonggi-do 16677 (KR); LIM, Jaehoon, Suwon-si Gyeonggi-do 16677 (KR); JEONG, Wontae, Suwon-si Gyeonggi-do 16677 (KR); SHIN, Moonchul, Suwon-si Gyeonggi-do 16677 (KR); YOO, Changhee, Suwon-si Gyeonggi-do 16677 (KR); CHO, Hyoungtak, Suwon-si Gyeonggi-do 16677 (KR); KIM, Yangwook, Suwon-si Gyeonggi-do 16677 (KR); HONG, Hyunju, Suwon-si Gyeonggi-do 16677 (KR)
(74) Representative: HGF
(86) International application number: PCT/KR2025/000170
(87) International publication number: WO 2025/159391

(57) **Abstract**

An electronic device according to an embodiment may comprise: a first housing part; a second housing part slidably coupled to the first housing part and including a first side surface and a second side surface opposite to the first side surface; and a motor disposed in the first housing part, positioned between the first side surface and the second side surface, and configured to slide the second housing part with respect to the first housing part. The second housing part may include a wall structure. The wall structure may comprise: a first part disposed around the motor; and a second part extending from the first part and connected to at least one of the first side surface and the second side surface.

## Description

### [Technical Field]

The present disclosure relates to an electronic device including a motor structure.

### [Background Art]

Beyond a general bar type, an electronic device with a slidable form factor capable of increasing or decreasing a size thereof is being developed. Such a slidable electronic device may include a slidable housing and a motor that provides a driving force for sliding the housing.

The above-described information may be provided as a related art for the purpose of helping understanding of the present disclosure. No claim or determination is raised as to whether any of the above-described descriptions may be applied as a prior art related to the present disclosure.

### [Disclosure]

### [Technical Solution]

An electronic device according to an embodiment may include a first housing part, a second housing part slidably coupled with respect to the first housing part and including a first side and a second side opposite to the first side, and a motor disposed in the first housing part, positioned between the first side and the second side, and configured to slide the second housing part with respect to the first housing part. The second housing part may include a wall structure. The wall structure may include a first portion disposed around the motor, and a second portion extending from the first portion and connected to at least one of the first side and the second side.

An electronic device according to an embodiment may include a first housing part, a second housing part slidably coupled with respect to the first housing part in a first direction and including a first side and a second side formed along the first direction, a motor disposed on a first plane substantially perpendicular to at least one of the first side and the second side between the first side and the second side in the second housing part and having a rotational axis in a second direction perpendicular to the first direction, a first wall formed around the motor substantially parallel to the second direction and disposed substantially perpendicular to the first plane, and at least one second wall extending from the first wall in the second direction.

An electronic device according to an embodiment may include a first housing part, a second housing part slidably coupled with respect to the first housing part in a first direction and including a first side and a second side formed along the first direction, a motor disposed on a first plane substantially perpendicular to the first side and the second side in the second housing part and having a rotational axis in a second direction perpendicular to the first direction, a pair of slide fixing supports coupled to be fixed to the first housing part, a pair of slide moving supports respectively coupled to the first side and the second side of the second housing part and slidably coupled to the pair of fixing supports in conjunction with sliding of the second housing part, and a pair of walls formed on the first plane. The first side and the second side may have opening areas such that the first side and the second side do not overlap the pair of slide fixing supports. The pair of walls may overlap the opening areas along the first direction.

### [Description of the Drawings]

FIG. 1 is a block diagram of an electronic device in a network environment according to various embodiments.
FIG. 2A is a top plan view of an exemplary electronic device in a first state, according to an embodiment.
FIG. 2B is a bottom view of an exemplary electronic device in a first state, according to an embodiment.
FIG. 2C is a top plan view of an exemplary electronic device 200 in a second state, according to an embodiment.
FIG. 2D is a bottom view of an exemplary electronic device 200 in a second state, according to an embodiment.
FIG. 3A is an exploded perspective view of an exemplary electronic device.
FIG. 3B is an exploded perspective view of an exemplary electronic device.
FIG. 4A is a cross-sectional view of an exemplary electronic device in a first state.
FIG. 4B is a cross-sectional view of an exemplary electronic device in a second state.
FIG. 5A is an exemplary top plan view of a second housing part according to an embodiment.
FIG. 5B is an exemplary side view of a second housing part according to an embodiment.
FIG. 5C is an exemplary perspective view of a second housing part according to an embodiment.
FIG. 6A is an exemplary perspective view illustrating a second housing part in which a PCB and a camera module are disposed, according to an embodiment.
FIG. 6B is an exemplary perspective view illustrating a second housing part according to an embodiment.
FIG. 6C is an exemplary cross-sectional view of a second housing part according to an embodiment.
FIG. 7A is an exemplary perspective view illustrating a second housing part to which a rail structure is coupled, according to an embodiment.
FIG. 7B is an exemplary cross-sectional view illustrating a rail structure and a second wall structure, according to an embodiment.
FIG. 7C is an exemplary diagram illustrating a second wall structure of a second housing part according to an embodiment.
FIG. 8 is a diagram illustrating vibration characteristics of a second housing part.
FIG. 9 is a graph illustrating vibration characteristics according to frequency of a second housing part according to an embodiment.
FIG. 10A is an exemplary top plan view of a second housing part according to an embodiment.
FIG. 10B is an exemplary diagram illustrating a motor structure according to an embodiment.
FIG. 10C is an exemplary cross-sectional view cut along line B-B' of FIG. 10A.
FIG. 10D is an exemplary cross-sectional view cut along line C-C' of FIG. 10A.
FIG. 10E is an exemplary cross-sectional view cut along line D-D' of FIG. 10A.
FIG. 11 is a diagram illustrating vibration displacement of a second housing part over time.
FIG. 12 is a diagram illustrating vibration displacement of a second housing part over time.
FIG. 13 is an exemplary diagram illustrating a motor structure disposed on a second housing part according to an embodiment.

### [Mode for Invention]

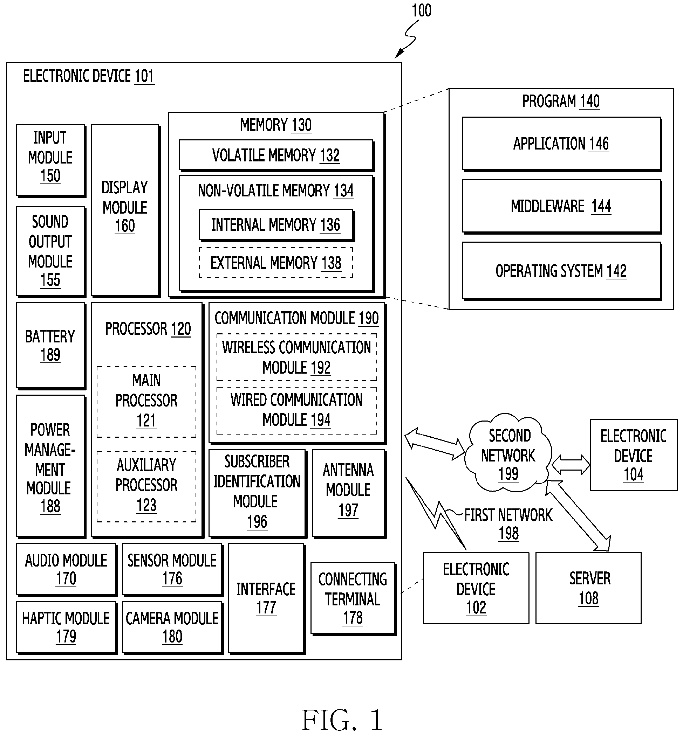

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

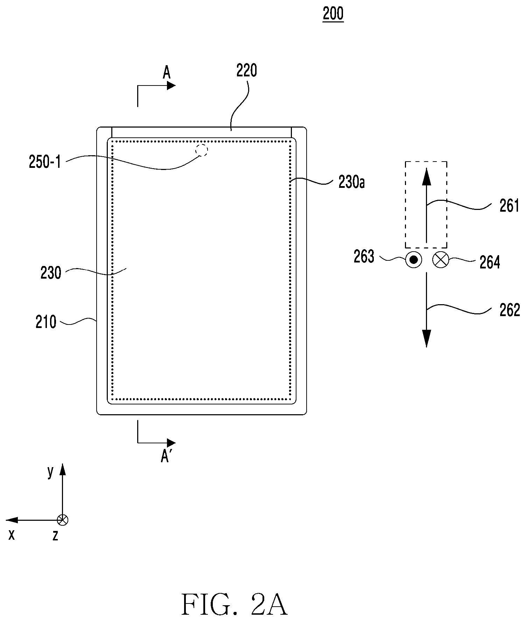

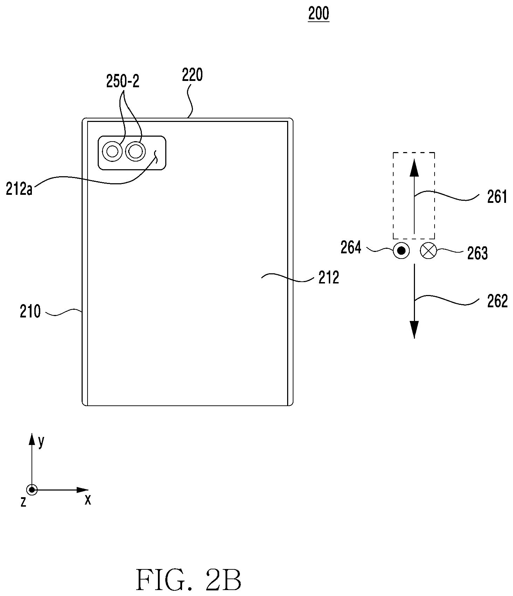

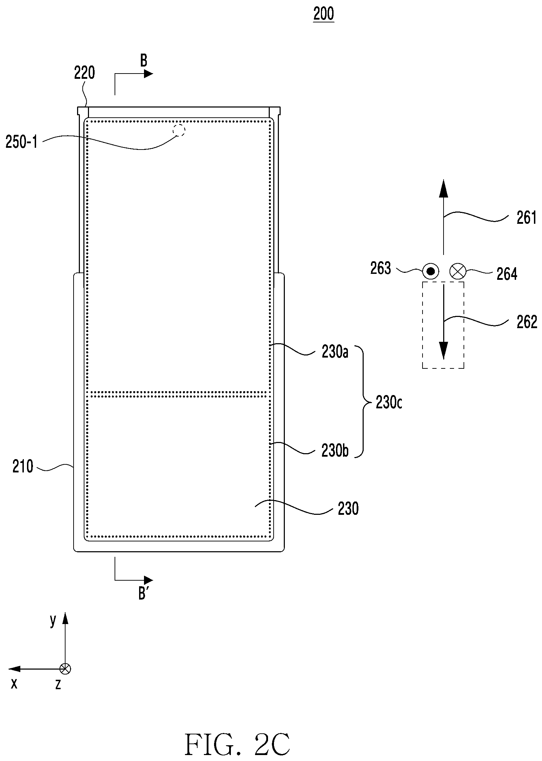

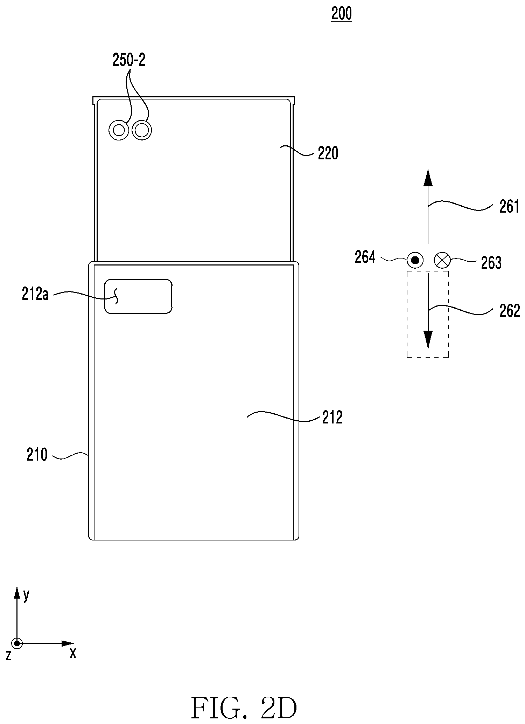

FIG. 2A is a top plan view of an exemplary electronic device in a first state, according to an embodiment. Referring to FIG. 2A, an electronic device 200 (e.g., the electronic device 101 of FIG. 1) may include a housing and a display 230 (e.g., the display module 160 of FIG. 1) at least partially accommodated in the housing. For example, the display 230 may be flexible. For example, the display 230 may provide at least a part of an exterior surface of the electronic device 200 and may include an area (or a display area) visually exposed to an outside of the housing of the electronic device 200. For example, since the display 230 has flexibility, at least a part of the display 230 may be rollable into the housing or slidable into the housing. For example, a size of the area (or the display area) of the display 230 visible from the outside may be changed according to a size of the at least a part of the display 230 rolled into the housing or slid into the housing. For example, the electronic device 200 including the display 230 may be in a plurality of states including a first state providing the display area having a first size and a second state providing the display area having a second size different from the first size. For example, the first state may be exemplified through descriptions of FIGS. 2A and 2B. For example, the second state may be exemplified through descriptions of FIGS. 2C and 2D.

In an embodiment, the housing of the electronic device 200 may include a first housing part 210 and a second housing part 220 movable with respect to the first housing part 210 in a first direction 261 parallel to a y-axis or a second direction 262 parallel to the y-axis and opposite to the first direction 261. Although the second housing part 220 has been described as being moved with respect to the first housing part 210, it is not limited thereto. For example, the first housing part 210 may be moved with respect to the second housing part 220. For example, according to a change in a relative positional relationship between the first housing part 210 and the second housing part 220, the size of the area (or the display area) of the display 230 visually exposed to the outside of the housing of the electronic device 200 may be changed.

For example, in the first state, the second housing part 220 may be movable with respect to the first housing part 210 in the first direction 261 between the first direction 261 and the second direction 262. For example, in the first state, the second housing part 220 may not be movable with respect to the first housing part 210 in the second direction 262.

For example, in the first state, the display 230 may provide the display area having the smallest size. For example, in the first state, the display area may correspond to a first area 230a. For example, although not illustrated in FIG. 2A, in the first state, an area (e.g., a second area 230b of FIG. 2C) of the display 230 different from the first area 230a, which is the display area, may be disposed in the first housing part 210. For example, in the first state, the second area 230b may be covered by the first housing part 210. For example, in the first state, the second area 230b may be moved into the first housing part 210. For example, at least a part of the second area 230b may be rollable into the first housing part 210. For example, in the first state, the first area 230a may include a planar portion. For example, in the first state, a part of the second area 230b may include a curved portion. However, it is not limited thereto. For example, the first area 230a may also include, in the first state, a curved portion extending from the planar portion.

For example, the first state may be referred to as a slide-in state in terms of at least a part of the second housing part 220 being positioned in the first housing part 210 according to the second housing part 220 slid toward the first housing part 210. For example, the first state may be referred to as a reduced state in terms of providing the display area having the smallest size. However, it is not limited thereto.

For example, the second housing part 220 may include a front camera 250-1 that obtains visual information through a part of the first area 230a and facing a third direction 263 parallel to a z-axis. For example, although not illustrated in FIG. 2A, the second housing part 220 may include one or more rear cameras (e.g., rear cameras 250-2 of FIG. 2B) visually exposed through a part of the second housing part 220 and facing a fourth direction 264 parallel to the z-axis and opposite to the third direction 263. For example, the one or more rear cameras 250-2 may be exemplified through description of FIG. 2B.

FIG. 2B is a bottom view of an exemplary electronic device in a first state, according to an embodiment.

Referring to FIG. 2B, in the first state, the one or more rear cameras 250-2 disposed in the second housing part 220 may be positioned within a structure disposed in the first housing part 210 for the one or more rear cameras 250-2. For example, since the one or more rear cameras 250-2 are positioned within the structure in the first state, the one or more rear cameras 250-2 may be visually exposed through the structure in the first state. The one or more rear cameras 250-2 may obtain visual information through the structure. For example, the structure may be variously implemented. For example, the structure may be an opening or a notch. For example, the structure may be an opening 212a in a first plate 212 of the first housing part 210 surrounding at least a part of the second housing part 220. However, it is not limited thereto.

Referring again to FIG. 1, the first state may be changed to the second state.

For example, the first state (or the second state) may be changed to the second state (or the first state) through one or more intermediate states between the first state and the second state.

For example, the first state (or the second state) may be changed to the second state (or the first state) based on a defined user input. For example, the first state (or the second state) may be changed to the second state (or the first state) in response to a user input for a physical button visually exposed through a part of the first housing part 210 or a part of the second housing part 220. There is no limitation on a type of the user input. For example, the user input may include a user input through a touch screen in the display area of the display 230 or a user input through a microphone of the electronic device 200. For example, a state of the electronic device 200 may be changed to the second state (or the first state), by an external force applied to the first housing part 210 and/or the second housing part 220. The second state may be exemplified through descriptions of FIGS. 2C and 2D.

FIG. 2C is a top plan view of an exemplary electronic device 200 in a second state, according to an embodiment.

Referring to FIG. 2C, in the second state, the second housing part 220 may be movable with respect to the first housing part 210 in the second direction 262 between the first direction 261 and the second direction 262. For example, in the second state, the second housing part 220 may not be movable with respect to the first housing part 210 in the first direction 261.

For example, in the second state, the display 230 may provide the display area having the largest size. For example, in the second state, the display area may correspond to an area 230c including the first area 230a and the second area 230b. For example, the second area 230b included in the first housing part 210 in the first state may be visually exposed in the second state. For example, in the second state, the first area 230a and the second area 230b may include a planar portion. However, it is not limited thereto. For example, the first area 230a and/or the second area 230b may also include a curved portion extending from the planar portion and positioned within an edge portion.

For example, the second state may be referred to as a slide-out state in terms of at least a part of the second housing part 220 being positioned outside the first housing part 210 according to the second housing part 220 slid from the first housing part 210. For example, the second state may be referred to as an expanded state in terms of providing the display area having the largest size. However, it is not limited thereto.

For example, the front camera 250-1 facing the third direction 263 may be moved together with the first area 230a according to movement of the second housing part 220 in the first direction 261 when the state of the electronic device 200 is changed from the first state to the second state. For example, although not illustrated in FIG. 2C, the one or more rear cameras (e.g., the rear cameras 250-2 of FIG. 2D) facing the fourth direction 264 may be moved together with the second housing part 220 according to the movement of the second housing part 220 in the first direction 261 when the state of the electronic device 200 is changed from the first state to the second state. For example, a relative positional relationship between the one or more rear cameras 250-2 and the structure exemplified through the description of FIG. 2B may be changed according to the movement of the one or more rear cameras 250-2. For example, the change in the relative positional relationship may be exemplified through FIG. 2D.

FIG. 2D is a bottom view of an exemplary electronic device 200 in a second state according to an embodiment.

Referring to FIG. 2D, in the second state, the one or more rear cameras 250-2 may be positioned outside the structure. For example, in the second state, the one or more rear cameras 250-2 may be positioned outside the opening 212a in the first plate 212. For example, since the one or more rear cameras 250-2 are positioned outside the opening 212a in the second state, the one or more rear cameras 250-2 may be visually exposed in the second state. The one or more rear cameras 250-2 positioned outside the structure may obtain visual information. For example, since the one or more rear cameras 250-2 are positioned outside the structure in the second state, the relative positional relationship between the one or more rear cameras 250-2 and the structure (e.g., the opening 212a) in the second state may be different from the relative positional relationship between the one or more rear cameras 250-2 and the structure (e.g., the opening 212a) in the first state (e.g., FIG. 2B).

Although not illustrated in FIGS. 2A, 2B, 2C, and 2D, the electronic device 200 may be in an intermediate state between the first state and the second state. For example, a size of the display area in the intermediate state may be larger than a size of the display area in the first state and may be smaller than a size of the display area in the second state. For example, the display area in the intermediate state may correspond to an area including the first area 230a and a part of the second area 230b. For example, in the intermediate state, the part of the second area 230b may be visually exposed, and another part (or a remaining part) of the second area 230b may be covered by the first housing part 210 or moved into the first housing part 210. However, it is not limited thereto.

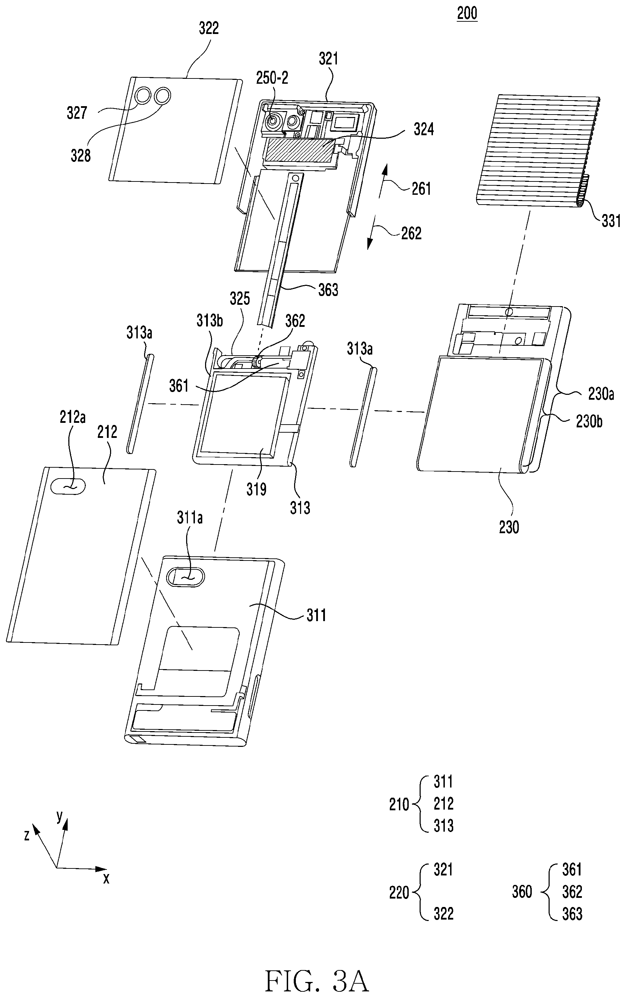

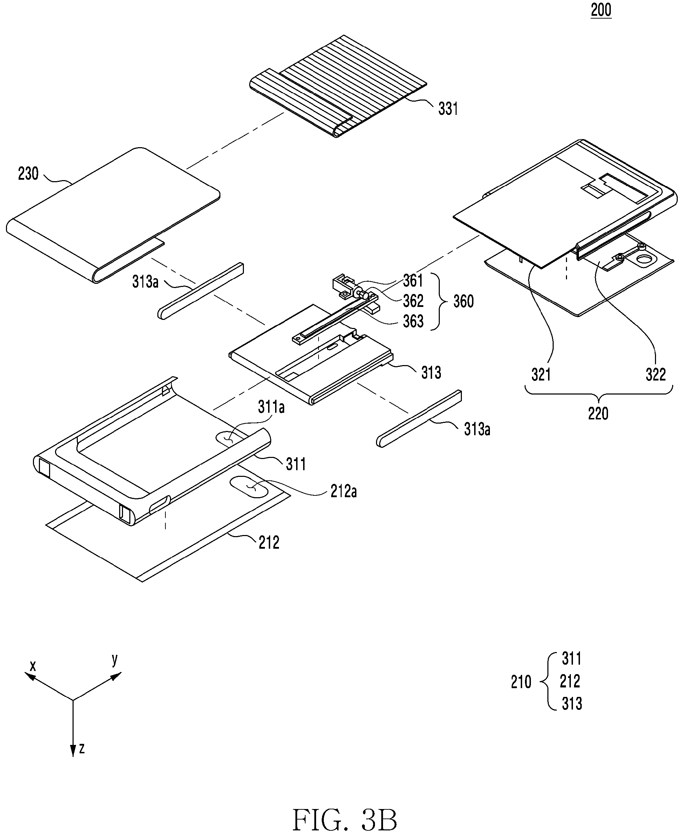

The electronic device 200 may include structures for moving a second housing part (e.g., the second housing part 220 of FIGS. 2A, 2B, 2C, and 2D) of the electronic device 200 with respect to a first housing part (e.g., the first housing part 210 of FIGS. 2A, 2B, 2C, and 2D) of the electronic device 200. For example, the structures may be exemplified through descriptions of FIGS. 3A and 3B.

In the present disclosure, description of configurations having the same reference numeral may be applied in the same or corresponding manner unless otherwise mentioned, even with reference to different drawings. In addition, redundant description for configuration having the same reference numeral may not be repeated.

FIGS. 3A and 3B are exploded perspective views of an exemplary electronic device.

Referring to FIGS. 3A and 3B, an electronic device 200 may include a first housing part 210, a second housing part 220, a display 230, and a driving unit 360.

In an embodiment, the first housing part 210 may include a first cover 311, a first plate 212, and a frame 313.

For example, the first cover 311 may at least partially form a side portion of an exterior surface of the electronic device 200. For example, the first cover 311 may at least partially form a rear portion of the exterior surface. For example, the first cover 311 may include an opening 311a for one or more rear cameras 250-2. For example, the first cover 311 may include a surface supporting the first plate 212. For example, the first cover 311 may be coupled with the first plate 212. For example, the first cover 311 may provide a space in which the frame 313 is seated. For example, the first cover 311 may be coupled with the frame 313.

For example, the first plate 212 may at least partially form the rear portion of the exterior surface. For example, the first plate 212 may include an opening 212a for the one or more rear cameras 250-2. For example, the first plate 212 may be disposed on the surface of the first cover 311. For example, the opening 212a may be aligned with the opening 311a.

For example, the frame 313 may be at least partially surrounded by the first cover 311. For example, the frame 313 may be at least partially surrounded by the display 230. For example, although the frame 313 may be at least partially surrounded by the display 230, a position of the frame 313 may be maintained independently of movement of the display 230. For example, the frame 313 may be arranged with respect to at least a part of components of the display 230. For example, the frame 313 may include rails 313a providing (or guiding) a path of movement of at least one component of the display 230.

For example, the frame 313 may be coupled with at least one component of the electronic device 200. For example, the frame 313 may support a rechargeable battery 319. For example, the battery 319 may be supported through a recess or a hole in a surface 313b of the frame 313. For example, the frame 313 may fix an end of a flexible printed circuit board (FPCB) 325 on a surface of the frame 313. The end of the FPCB 325 may be electrically connected with a motor structure 361. For example, although not explicitly illustrated in FIGS. 3A and 3B, another end of the FPCB 325 may be connected with a printed circuit board (PCB) 324 through at least one connector. For example, the PCB 324 may be electrically connected, through the FPCB 325, with another PCB (not illustrated in FIGS. 3A and 3B) supplying power to the motor structure 361.

For example, the frame 313 may be coupled with at least one structure of the electronic device 200 for a plurality of states including the first state and the second state. For example, the frame 313 may fix (fasten) a rack gear 363 of the driving unit 360.

For example, the second housing part 220 may movably engage with the first housing part 210. The second housing part 220 may include a second cover 321 and a second plate 322.

For example, the second cover 321 may be at least partially surrounded by the display 230. For example, unlike the frame 313, the second cover 321 may be coupled with at least a part of a first area 230a of the display 230 surrounding the second cover 321 such that the display 230 is moved according to the second housing part 220 moved with respect to the first housing part 210.

For example, the second cover 321 may be coupled with at least one component of the electronic device 200. For example, the second cover 321 may be coupled with the PCB 324 including components of the electronic device 200. For example, the PCB 324 may include a processor 120 (not illustrated in FIGS. 3A and 3B). For example, the second cover 321 may be coupled with the one or more rear cameras 250-2.

For example, the second cover 321 may be coupled with at least one structure of the electronic device 200 for the plurality of states including the first state and the second state. For example, the second cover 321 may fix the motor structure 361 of the driving unit 360. The second cover 321 may be referred to as a bracket of the second housing part 220.

For example, the motor structure 361 of the driving unit 360 may be fixed to the second cover 321, and the rack gear 363 of the driving unit 360 may be fixed to the frame 313.

For example, the second cover 321 may be coupled with the second plate 322. For example, in order to protect at least one component of the electronic device 200 coupled in the second cover 321 and/or at least one structure of the electronic device 200 coupled in the second cover 321, the second plate 322 may be coupled with the second cover 321. For example, the second plate 322 may include a structure for the at least one component. For example, the second plate 322 may include one or more openings 327 and 328 for the one or more rear cameras 250-2. For example, the one or more openings 327 and 328 may be aligned with the one or more rear cameras 250-2 disposed on the second cover 321. For example, a size of each of the one or more openings 327 and 328 may correspond to a size of each of the one or more rear cameras 250-2.

For example, the display 230 may include a supporting member 331. For example, the supporting member 331 may include a plurality of bars. For example, the plurality of bars may be coupled with each other. The supporting member 331 may support a second area 230b of the display 230.

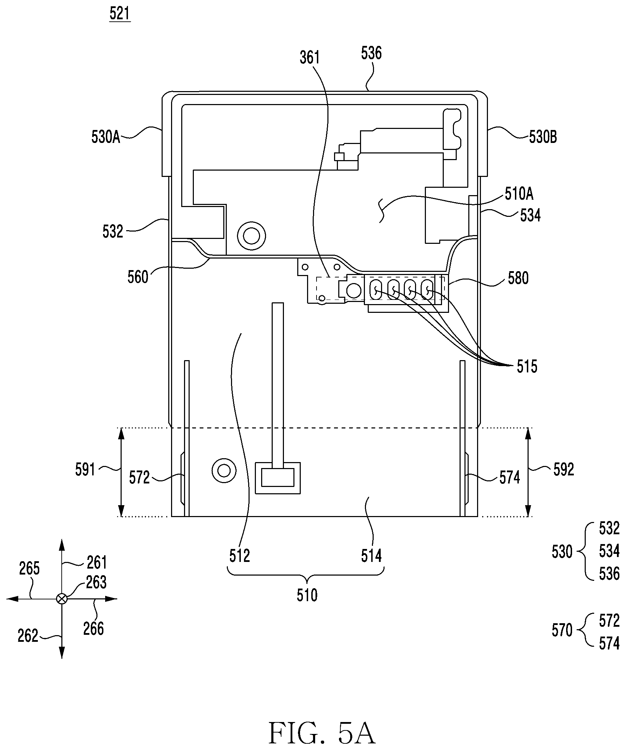

For example, the driving unit 360 may include the motor structure 361, a pinion gear 362, and the rack gear 363. For example, the motor structure 361 may operate based on power from the battery 319. For example, the power may be provided to the motor structure 361 in response to the defined user input. The motor structure 361 may provide torque for sliding of the first housing part 210 and the second housing part 220. Due to the operation of the motor structure 361, vibration may be transmitted to the second housing part 220. The vibration transmitted to the second housing part 220 may be amplified by the second housing part 220, and thus unpleasant noise may occur. The second housing part 220 according to an embodiment may include a wall structure capable of reducing or preventing noise caused by the transmitted vibration by avoiding resonance due to driving frequency of the motor structure 361. The wall structure is described later with reference to FIGS. 5A to 13.

For example, the pinion gear 362 may be coupled with the motor structure 361 through a shaft. For example, the pinion gear 362 may be rotated based on the operation of the motor structure 361 transmitted through the shaft.

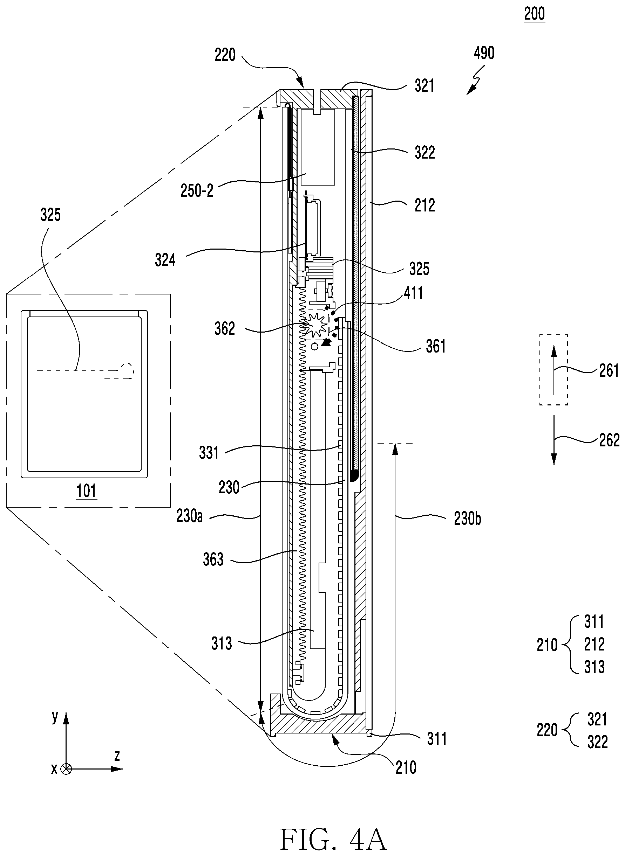

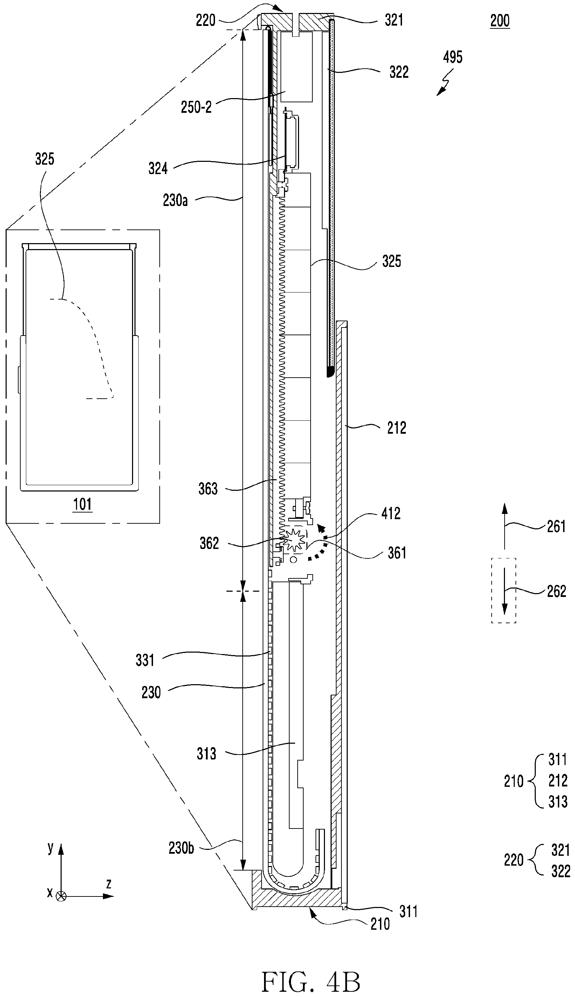

For example, the rack gear 363 may be arranged in relation to the pinion gear 362. For example, teeth of the rack gear 363 may engage with teeth of the pinion gear 362. For example, the rack gear 363 may move in a first direction 261 or a second direction 262 according to rotation of the pinion gear 362. The second housing part 220 may move in the first direction 261 or the second direction 262 according to movement of the rack gear 363 fixedly coupled to the first housing part 210. For example, the first state of the electronic device 200 may be changed to a state (e.g., the one or more intermediate states or the second state) different from the first state through the movement of the second housing part 220 in the first direction 261. For example, the second state of the electronic device 200 may be changed to a state (e.g., the one or more intermediate states or the first state) different from the second state through the movement of the second housing part 220 in the second direction 262. For example, the first state being changed to the second state by the driving unit 360 and the second state being changed to the first state by the driving unit 360 may be exemplified through FIGS. 4A and 4B.

FIG. 4A is a cross-sectional view of an exemplary electronic device in a first state. FIG. 4B is a cross-sectional view of an exemplary electronic device in a second state.

Referring to FIGS. 4A and 4B, a motor structure 361 may be operated based at least in part on the defined user input received in the first state 490. For example, a pinion gear 362 may be rotated in a first rotational direction 411 based at least in part on the operation of the motor structure 361. For example, a rack gear 363 may move in a first direction 261 based at least in part on the rotation of the pinion gear 362 in the first rotational direction 411. For example, since the motor structure 361 to which the pinion gear 362 is connected is fixed with respect to a second housing part 220, and the rack gear 363 is fixed with respect to a first housing part 210, the second housing part 220 may move in the first direction 261 with respect to the first housing part 210 based at least in part on the movement of the rack gear 363 in the first direction 261. For example, since a second cover 321 in the second housing part 220 is coupled with at least a part of a first area 230a of a display 230, the display 230 may move in the first direction 261 based at least in part on the movement of the rack gear 363 in the first direction 261. For example, the display 230 may move along the rails 313a of FIG. 3B. For example, as a supporting member 331 moves in the first direction 261 along the rails 313a, the display 230 supported by the supporting member 331 may move in the first direction 261. For example, a shape of at least a part of the plurality of bars of the supporting member 331 of the display 230 may be changed when the first state 490 is changed to the second state 495.

For example, a second area 230b of the display 230 may move according to the movement of the display 230. For example, the second area 230b may move through a space between a first cover 311 and a frame 313 when the first state 490 is changed to the second state 495 according to the defined user input. For example, the second area 230b in the second state 495 may be visually exposed, unlike the second area 230b rolled into the space in the first state 490.

For example, since the second cover 321 in the second housing part 220 is coupled with a PCB 324 connected with the another end of an FPCB 325 and fixes the rack gear 363, a shape of the FPCB 325 may be changed when the first state 490 is changed to the second state 495.

The motor structure 361 may be operated based at least in part on the defined user input received in the second state 495. For example, the pinion gear 362 may be rotated in a second rotational direction 412 based at least in part on the operation of the motor structure 361. For example, the rack gear 363 may move in a second direction 262 based at least in part on the rotation of the pinion gear 362 in the second rotational direction 412. For example, the second housing part 220 may move in the second direction 262 based at least in part on the movement of the rack gear 363 in the second direction 262. For example, the display 230 may move based at least in part on the movement of the rack gear 363 in the second direction 262. As the supporting member 331 moves in the second direction 262 along the rails 313a, the display 230 supported by the supporting member 331 may move in the second direction 262. For example, the display 230 may move along rails (e.g., the rails 313a of FIG. 3B). For example, a shape of at least a part of the plurality of bars of the supporting member 331 of the display 230 may be changed when the second state 495 is changed to the first state 490. The supporting member 331 may move with respect to the first housing part 210. The supporting member 331 accommodated inside the first housing part 210 in the first state 490 may be positioned between the first cover 311 and the frame 313. According to the movement of the supporting member 331, the display 230 may move with respect to the first housing part 210.

For example, the second area 230b of the display 230 may move according to the movement of the display 230. For example, the second area 230b may move through the space between the first cover 311 and the frame 313 when the second state 495 is changed to the first state 490 according to the defined user input. For example, the second area 230b in the first state 490 may be rolled into the space, unlike the second area 230b visually exposed in the second state 495.

For example, since the second cover 321 in the second housing part 220 is coupled with the PCB 324 connected with the another end of the FPCB 325 and fixes the rack gear 363, a shape of the FPCB 325 may be changed when the second state 495 is changed to the first state 490.

Although FIGS. 2A to 4B illustrate an electronic device 200 in which a height of the display area is changed and a width of the display area is maintained when the first state (or the second state) is changed to the second state (or the first state) in a portrait mode, it is for convenience of description. For example, the electronic device 200 may be implemented with the height of the display area being maintained and the width of the display area being changed when the first state (or the second state) is changed to the second state (or the first state) in the portrait mode.

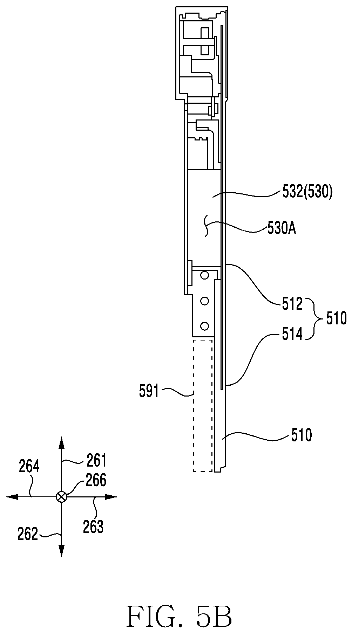

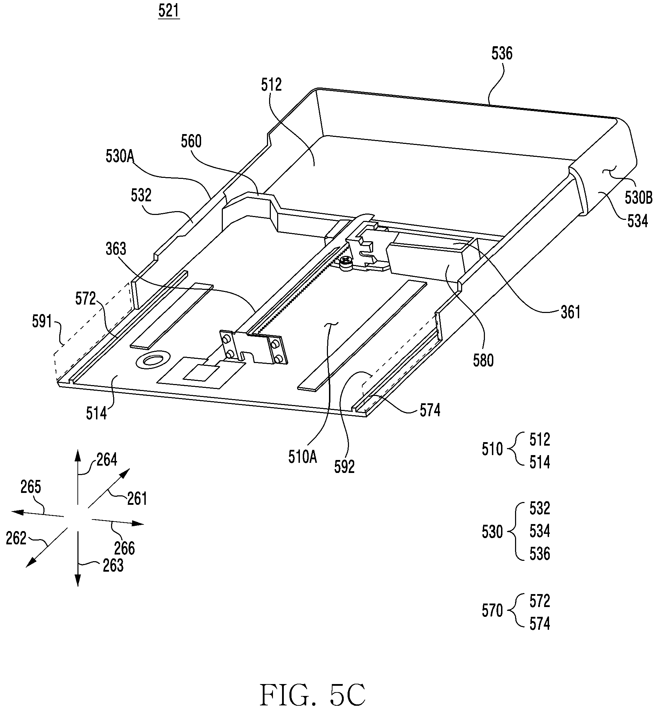

FIG. 5A is an exemplary top plan view of a second housing part according to an embodiment. In FIG. 5A, a motor structure 361 is also illustrated for convenience of description. FIG. 5B is an exemplary side view of a second housing part according to an embodiment. FIG. 5C is an exemplary perspective view of a second housing part according to an embodiment. In FIG. 5C, the motor structure 361 and a rack gear 363 are also illustrated for convenience of description.

In FIGS. 5A, 5B, and 5C, a fifth direction 265 and a sixth direction 266 may be directions perpendicular to a first direction 261 and a second direction 262, which are sliding directions of a second housing part 521, and perpendicular to a third direction 263 (e.g., the z-axis direction of FIG. 4B), which is a thickness direction of the second housing part 521. The sixth direction 266 may be opposite to the fifth direction 265.

Referring to FIGS. 5A, 5B, and 5C, an electronic device 200 according to an embodiment may include the second housing part 521 (e.g., the second housing part 220 of FIG. 3B or the second cover 321 of the second housing part 220).

In an embodiment, the second housing part 521 may include a supporting plate 510 on which the motor structure 361 is disposed and a sidewall 530 partially covering the supporting plate 510.

In an embodiment, the second housing part 521 may include a first side 530A and a second side 530B facing a direction opposite to the first side 530A. The first side 530A may be formed along the first direction 261. For example, the first side 530A may extend along the first direction 261. The second side 530B may be formed along the first direction 261. For example, the second side 530B may extend along the first direction 261. The second side 530B may be parallel to the first side 530A.

In an embodiment, the second housing part 521 (or the supporting plate 510) may include a plane 510A substantially perpendicular to the first side 530A and the second side 530B. Various configurations, such as the motor structure 361, a battery (e.g., the battery 319 of FIG. 3A), and a printed circuit board (e.g., the PCB 324 of FIG. 3A), may be disposed on the plane 510A. Although not illustrated, the second housing part 521 (or the supporting plate 510) may include a surface (or a second plane) opposite to the plane 510A and supporting a display (e.g., the first area 230a of the display 230 of FIG. 3A) of the electronic device 200.

In an embodiment, a first sidewall 532 may form at least a part of the first side 530A, and a second sidewall 534 may form at least a part of the second side 530B. In an embodiment, a first opening area 591 may be formed in the first side 530A, and a second opening area 592 may be formed in the second side 530B. Each of the first opening area 591 and the second opening area 592 may extend along a sliding direction (e.g., the first direction 261) of the second housing part 521. In an embodiment, as the first sidewall 532 is not formed in the first opening area 591, a second portion 514 of the supporting plate 510 may be open. In this case, the first side 530A may be formed by the second portion 514 of the supporting plate 510 and the first sidewall 532. Alternatively, unlike the illustration, the first sidewall 532 may be formed in the first opening area 591, and in this case, the first sidewall 532 may be formed to have a lower height in the first opening area 591 than in another area. In an embodiment, as the second sidewall 534 is not formed in the second opening area 592, the second portion 514 of the supporting plate 510 may be open. In this case, the second side 530B may be formed by the second portion 514 of the supporting plate 510 and the second sidewall 534. Alternatively, unlike the illustration, the second sidewall 534 may be formed in the second opening area 592, and in this case, the second sidewall 534 may be formed to have a lower height in the second opening area 592 than in another area.

In an embodiment, the first sidewall 532 and the second sidewall 534 may be substantially parallel to the sliding direction of the second housing part 521. For example, the first sidewall 532 and the second sidewall 534 may be substantially parallel to the first direction 261 and the second direction 262.

In an embodiment, the supporting plate 510 and the sidewall 530 of the second housing part 521 may be integrally formed, but are not limited thereto. For example, at least a part of the sidewall 530 may be coupled to the supporting plate 510.

In an embodiment, the second housing part 521 may be formed of metal and/or plastic. For example, the supporting plate 510 and/or the sidewall 530 may be formed of metal and/or plastic.

In an embodiment, the supporting plate 510 may include a first portion 512 covered by the sidewall 530 and a second portion 514 extending from the first portion 512. For example, the first portion 512 may be surrounded by the first sidewall 532, the second sidewall 534, and a third sidewall 536. The second portion 514 may not be surrounded by the sidewall 530. The second portion 514 may extend from the first portion 512 toward a first housing part (210 of FIG. 4B).

In an embodiment, at least a partial section of the sidewall 530 may be formed to have a thickness (e.g., a length according to the third direction 263 or a fourth direction 264) thicker than the supporting plate 510. For example, the first sidewall 532 and the second sidewall 534 may be thicker than the supporting plate 510.

In an embodiment, at least a partial section of the sidewall 530 may protrude from the supporting plate 510. For example, at least a partial section of the sidewall 530 may protrude from the plane 510A of the supporting plate 510. For example, the first sidewall 532 and the second sidewall 534 may protrude in the fourth direction 264 from the plane 510A of the supporting plate 510. The plane 510A may include, for example, a surface of the supporting plate 510 facing an opposite direction (e.g., the fourth direction 264) to a display area (e.g., the first area 230a and/or the second area 230b of FIG. 2A) of a display (e.g., the display 230 of FIG. 2A) visible from an outside of the electronic device 200.

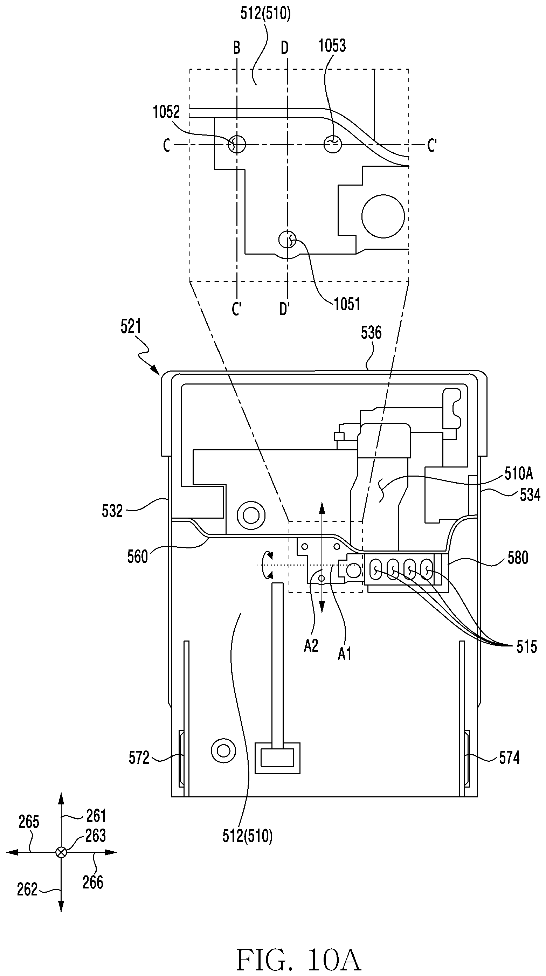

In an embodiment, the motor structure 361 may be disposed on the plane 510A of the supporting plate 510. For example, the motor structure 361 may be disposed on the first portion 512 of the supporting plate 510. For example, the motor structure 361 may be coupled to the supporting plate 510. The coupling structure between the motor structure 361 and the supporting plate 510 is exemplified through descriptions of FIGS. 10A to 10E.

In an embodiment, holes 515 passing through the supporting plate 510 may be formed in the supporting plate 510 to accommodate the motor structure 361, but are not limited thereto. For example, at least a part of the holes 515 may be formed as a groove formed on the plane 510A of the supporting plate 510. In addition, although the plurality of holes 515 are illustrated, it is not limited thereto, and the holes 515 may be formed as one hole.

Vibration transmitted from the motor structure 361 to the second housing part 521 may be amplified by the second housing part 521, and thereby unpleasant noise may occur. The second housing part 521 according to an embodiment may include a wall structure capable of reducing or preventing noise caused by the transmitted vibration by avoiding resonance due to driving frequency of the motor structure 361.

For example, the second housing part 521 may include a first wall structure 560. For example, the first wall structure 560 may be formed on a portion of the second housing part 521 having a relatively thin thickness. The first wall structure 560 may extend between portions of the second housing part 521 having relatively thick thicknesses. The first wall structure 560 may mitigate the vibration transmitted from the motor structure 361 to the second housing part 521. Accordingly, occurrence of noise due to the portion of the second housing part 521 having a relatively thin thickness, which is relatively vulnerable to vibration, may be decreased or prevented.

For example, the first wall structure 560 may be positioned on the supporting plate 510 thinner than the sidewall 530. For example, the first wall structure 560 may be positioned on the first portion 512 of the supporting plate 510. For example, the first wall structure 560 may be formed (or disposed) to be substantially perpendicular to the plane 510A on the plane 510A of the second housing part 521. For example, the first wall structure 560 may protrude from the plane 510A in a thickness direction (e.g., the fourth direction 264) of the supporting plate 510. For example, the first wall structure 560 may extend between the first sidewall 532 and the second sidewall 534 thicker than the supporting plate 510. The first wall structure 560 extending between the first sidewall 532 and the second sidewall 534 is not interpreted as the first wall structure 560 being fully connected to the first sidewall 532 and the second sidewall 534. For example, the first wall structure 560 may connect the first sidewall 532 and the second sidewall 534 by extending from the first sidewall 532 to the second sidewall 534. For another example, the first wall structure 560 may be disconnected at one or more sections formed at substantially the same height as the plane 510A and/or formed at a lower height than neighboring sections.

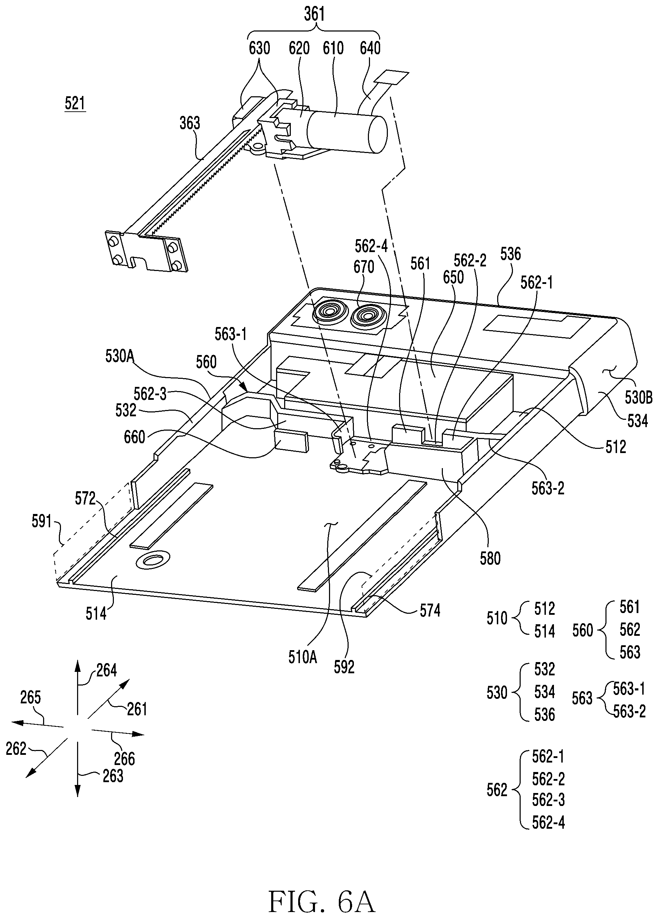

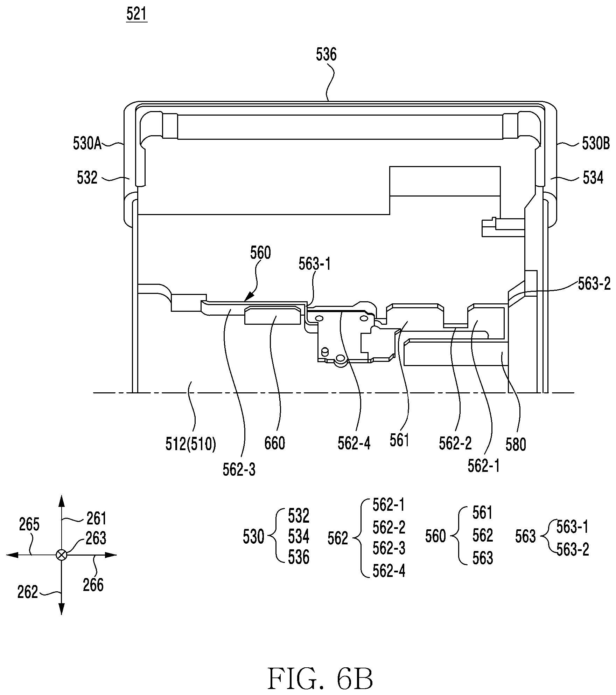

In an embodiment, the first wall structure 560 may at least partially cross the supporting plate 510. For example, the first wall structure 560 may extend in one or more directions (e.g., the sixth direction 266) toward the second sidewall 534 from the first sidewall 532. For example, the first wall structure 560 may extend from the first sidewall 532 to the second sidewall 534. The first wall structure 560 may be positioned adjacent to the motor structure 361. For example, the first wall structure 560 may extend across a side of the motor structure 361. For example, the first wall structure 560 may extend along the motor structure 361. For example, the first wall structure 560 may include a section (e.g., a first wall 561 of FIG. 6A) surrounding the motor structure 361. In an embodiment, the rack gear 363 may move along a sliding path of the second housing part 521 above the first wall structure 560 (e.g., in the fourth direction 264). In order not to interfere with the movement of the rack gear 363, the first wall structure 560 may include a section (e.g., a fourth section 562-4 of FIG. 6B) formed to have a relatively low height.

For example, the second housing part 521 may include a second wall structure 572 or 574. The second wall structure 572 or 574 may be formed on a portion of the supporting plate 510 on which the sidewall 530 is not formed. For example, the second wall structure 572 or 574 may be formed on a portion in which the sidewall 530 is not formed and in which the second housing part 521 has a relatively thin thickness. For example, the second wall structure 572 or 574 may be formed adjacent to the first opening area 591 and the second opening area 592. Since the portion in which the second wall structure 572 or 574 is positioned is not only not covered by the sidewall 530 but also has a relatively thin thickness, it may be relatively vulnerable to vibration transmitted from the motor structure 361. As the second wall structure 572 or 574 is formed on such portion, noise due to vibration transmitted from the motor structure 361 may be reduced or prevented.

For example, the second wall structure 572 or 574 may include a first wall 572 and a second wall 574. The first wall 572 and the second wall 574 may be positioned on the second portion 514 of the supporting plate 510 positioned outside the sidewall 530. For example, the first wall 572 and the second wall 574 may extend vertically from the plane 510A of the second portion 514. In an embodiment, a position of the first wall 572 on the supporting plate 510 may be opposite to a position of the second wall 574 on the supporting plate 510. For example, the first wall 572 may be adjacent to the first opening area 591 of the supporting plate 510 (e.g., the second portion 514), and the second wall 574 may be adjacent to the second opening area 592 of the supporting plate 510 (e.g., the second portion 514). In an embodiment, the first wall 572 may extend in the first direction 261 along the first opening area 591 of the supporting plate 510. For example, the first wall 572 may be substantially parallel to the first sidewall 532. In an embodiment, the second wall 574 may extend in the first direction 261 along the second opening area 492 of the supporting plate 510. For example, the second wall 574 may be substantially parallel to the second sidewall 534. In an embodiment, the first wall 572 may have a lower height than the first sidewall 532, but is not limited thereto. In an embodiment, the second wall 574 may have a lower height than the second sidewall 534, but is not limited thereto. Although not illustrated, the second wall structure 572 or 574 may further include another wall protruding on the second portion 514 to connect the first wall 572 and the second wall 574.

In an embodiment, the first wall 572 may include a section overlapping the first opening area 591. The first wall 572 may include a section overlapping the first opening area 591 along the first direction 261. In an embodiment, the second wall 574 may include a section overlapping the second opening area 592. The second wall 574 may include a section overlapping the second opening area 592 along the first direction 261.

For example, the second housing part 521 may include a third wall structure. The third wall structure may at least partially cover the motor structure 361 transmitting vibration capable of causing noise. The third wall structure may reduce or prevent noise according to the transmitted vibration being amplified in the second housing part 521 by being disposed at a peripheral portion of the motor structure 361, which is a vibration source.

For example, the third wall structure may include a partial section (e.g., the first wall 561 and a first section 562-1 of FIG. 6A) of the first wall structure 560 covering the motor structure 361 and a fourth wall 580 extending from the first wall structure 560. The fourth wall 580 may protrude on the first portion 512 of the supporting plate 510 to cover the motor structure 361. The partial section of the first wall structure 560 and the fourth wall 580 may be formed to have a height equal to or higher than a height of the motor structure 361, but is not limited thereto.

In an embodiment, at least one (or at least a part) of the first wall structure 560, the second wall structure 572 or 574, and/or the fourth wall 580 may be integrally formed with the supporting plate 510, but is not limited thereto. For example, at least one (or at least a part) of the first wall structure 560, the second wall structure 572 or 574, and/or the fourth wall 580 may be formed as a piece separate from the supporting plate 510 and may be mechanically coupled or attached to the supporting plate 510.

In an embodiment, the first wall structure 560, the second wall structure 572 or 574, or the fourth wall 580 may be referred to as a wall, a wall structure, a partition structure, a reinforcement wall, a reinforcement structure, a protruding portion, a protruding surface, a sidewall, a separation wall, a vibration damping structure, a column, a beam (in a case of being referred to as the 'beam', a wall may be at least partially spaced from the plane 510A), a cross wall, or a crossbar, but are not limited by the above-described examples.

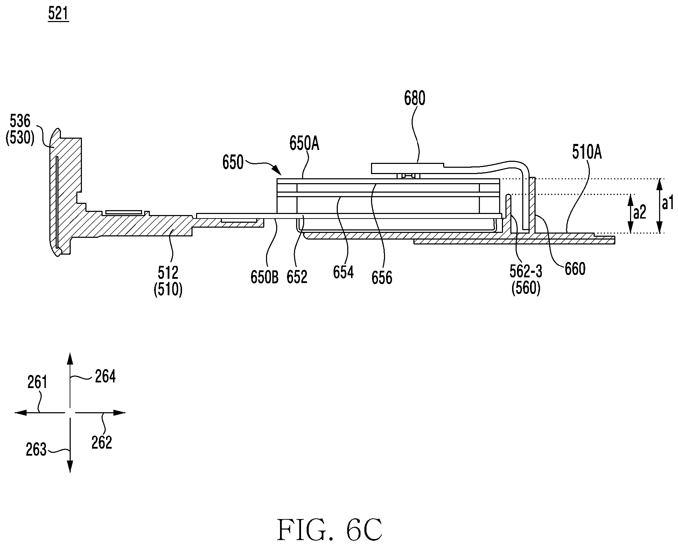

FIG. 6A is an exemplary perspective view illustrating a second housing part in which a PCB and a camera module are disposed, according to an embodiment. FIG. 6B is an exemplary perspective view illustrating a second housing part according to an embodiment. FIG. 6C is an exemplary cross-sectional view of a second housing part according to an embodiment. FIG. 6C may be a cross-sectional view cut along line A-A' of FIG. 6A.

Referring to FIG. 6A, an electronic device 200 according to an embodiment may include a camera module 670 (e.g., the camera module 180 of FIG. 1) and a PCB 650 (e.g., the PCB 324 of FIG. 3A). The camera module 670 may include one or more cameras (e.g., the rear cameras 250-2 of FIG. 2B) arranged to face a rear direction (e.g., a fourth direction 264) of a second housing part 521. The camera module 670 may be disposed on the second housing part 521. For example, the camera module 670 may be disposed on a plane 510A of a supporting plate 510. The PCB 650 may be disposed on the second housing part 521. For example, the PCB 650 may be disposed on the plane 510A of the supporting plate 510.

In an embodiment, a first wall structure 560 may be positioned between the PCB 650 and a motor structure 361. For example, the PCB 650 may be positioned on a side (e.g., in a first direction 261) of the first wall structure 560, and the motor structure 361 may be positioned on another side (e.g., in a second direction 262) of the first wall structure 560. The PCB 650 may be positioned between the camera module 670 and the first wall structure 560. However, it is not limited by the above-described example. For example, the first wall structure 560 may be positioned below the motor structure 361 (e.g., in the second direction 262). For another example, the second housing part 521 may further include, in addition to the first wall structure 560, a wall or a wall structure connecting a first sidewall 532 and a second sidewall 534 below the motor structure 361 (e.g., in the second direction 262).

In an embodiment, the motor structure 361 may include a motor (or a motor core) 610 including a rotor and a stator for generating torque from electrical energy, a reducer 620 for adjusting torque by the motor 610, a motor bracket 630 for coupling the motor structure 361 to the second housing part 521, and an FPCB 640 electrically connecting the motor structure 361 and the PCB 650. The motor bracket 630 may support the motor 610 and/or the reducer 620. The motor bracket 630 may be fixedly coupled to the supporting plate 510 of the second housing part 521.

Referring to FIGS. 6A and 6B, the first wall structure 560 according to an embodiment may include a first wall 561, a second wall 562, and a third wall 563. The first wall 561 may be substantially perpendicular to the first sidewall 532 or the second sidewall 534, and/or may be substantially parallel to a rotational axis (e.g., the axis of the first rotational direction 411 of FIG. 4A or the axis of the second rotational direction 412 of FIG. 4B) of the motor structure 361. The first wall 561 may be adjacent to the motor 610. For example, the first wall 561 may be positioned around the motor 610. The first wall 561 may be spaced apart from the motor 610. The rotational axis of the motor structure 361 may be substantially perpendicular to a sliding direction (e.g., the first direction 261) of the second housing part 521.

In an embodiment, the second wall 562 may extend from the first wall 561. The second wall 562 may include at least one section (or wall) substantially perpendicular to the first sidewall 532 or the second sidewall 534 and/or substantially parallel to the rotational axis of the motor structure 361. For example, the at least one section of the second wall 562 may include at least one of a first section 562-1, a second section 562-2, a third section 562-3, and a fourth section 562-4. Each of the first section 562-1, the second section 562-2, the third section 562-3, and the fourth section 562-4 of the second wall 562 may be referred to as one wall, and the second wall 562 including the same may be referred to as at least one second wall.

In an embodiment, the first wall 561 may be positioned between the second section 562-2 and the fourth section 562-4 of the second wall 562. For example, the second section 562-2 may extend from a side of the first wall 561, and the fourth section 562-4 may extend from another side of the first wall 561.

In an embodiment, the first section 562-1 of the second wall 562 may be connected to the first wall 561 through the second section 562-2. The second section 562-2 may be formed to have a lower height than the first section 562-1 and/or the first wall 561.

In an embodiment, the third section 562-3 of the second wall 562 may be connected to the first sidewall 532. The third section 562-3 may be connected to the first wall 561 through the fourth section 562-4. The fourth section 562-4 may be formed to have a lower height than the third section 562-3 and/or the first wall 561.

In an embodiment, the third wall 563 may include at least one section (or wall) extending from the first wall 561 and/or the second wall 562 in a different direction from the first wall 561 and the second wall 562. For example, the at least one section of the third wall 563 may include a first section 563-1 and/or a second section 563-2. Each of the first section 563-1 and the second section 563-2 may be referred to as one wall, and the third wall 563 including the same may be referred to as at least one third wall.

In an embodiment, the first section 563-1 of the third wall 563 may extend, from a portion of the second wall 562 at which the third section 562-3 and the fourth section 562-4 of the second wall 562 meet, in a different direction (e.g., the second direction 262) from the second wall 562-2. The second section 563-2 of the third wall 563 may extend, from a portion at which the first section 562-1 of the second wall 562 and a fourth wall 580 meet, in a different direction (e.g., the first direction 261) from the second wall 562. The second section 562-2 of the third wall 563 may connect the first section 562-1 of the second wall 562 to the second sidewall 534.

The first wall structure 560 according to an embodiment may include one or more first sections substantially perpendicular to the first sidewall 532 and the second sidewall 534 and/or substantially parallel to the rotational axis (e.g., the axis of the first rotational direction 411 of FIG. 4A or the axis of the second rotational direction 412 of FIG. 4B) of the motor structure 361. For example, the one or more first sections may include the first wall 561 and the second wall 562, but are not limited thereto.

In an embodiment, in order to provide a path through which a rack gear 363 passes, the first wall structure 560 may include one or more second sections formed to have a relatively low height. For example, the one or more second sections may include the fourth section 562-4 of the second wall 562. The fourth section 562-4 of the second wall 562 may be formed to have a lower height than the first wall 561 and/or the third section 562-3 connected to both sides of the fourth section 562-4. The rack gear 363 may be positioned, for example, between the first wall 561 and the third section 562-3 above the fourth section 562-4. The rack gear 363 may move, for example, between the third section 562-3 of the second wall 562 and the first wall 561, and above the fourth section 562-4, along a path parallel to the sliding direction of the second housing part 521. Alternatively or optionally, the fourth section 562-4 of the second wall 562 may be formed to have substantially the same height as the plane 510A. That is, the second wall 562 may not include the fourth section 562-4.

In an embodiment, in order to provide a path through which the FPCB 640 of the motor structure 361 passes, the first wall structure 560 may include one or more third sections formed to have a relatively low height. For example, the one or more third sections may include the second section 562-2 of the second wall 562. The second section 562-2 of the second wall 562 may be formed to have a lower height than the third section 562-3 and/or the first wall 561 connected to both sides of the second section 562-2. The FPCB 640 of the motor structure 361 may extend across the second section 562-2 of the second wall 562 so as to pass a portion between the first section 562-1 of the second wall 562 and the first wall 561. For example, the FPCB 640 of the motor structure 361 may extend on or above the second section 562-2 of the second wall 562.

The first wall structure 560 according to an embodiment may include one or more fourth sections substantially parallel to the rotational axis (e.g., a fifth direction 265) of the motor structure 361 and extending along the motor structure 361. For example, the one or more fourth sections may include the sections 562-1 and 562-2 of the second wall 562 and the first wall 561, but are not limited thereto.

The first wall structure 560 according to an embodiment may include one or more fifth sections extending in a direction different from the rotational axis of the motor structure 361. For example, the one or more fifth sections may include the third wall 563, but are not limited thereto. In an embodiment, each of the sections of the first wall structure 560 may be referred to as a wall.

Referring to FIG. 6C, the electronic device 200 may include an FPCB 680 (e.g., the FPCB 325 of FIGS. 4A and 4B) connected to the PCB 650. The PCB 650 according to an embodiment may include a plurality of boards stacked on each other. For example, the PCB 650 may include a first board 652, a second board 654 stacked on the first board 652, and a third board 656 stacked on the second board 654. In an embodiment, the PCB 650 may include a first connection board interposed between the first board 652 and the second board 654 and a second connection board interposed between the second board 654 and the third board. The first connection board and the second connection board may include an interposer. In an embodiment, the PCB 650 may include an upper surface 650A and a lower surface 650B opposite to the upper surface 650A and facing the plane 510A of the supporting plate 510. The upper surface 650A may be, for example, a surface of a board positioned at the uppermost layer among the plurality of boards of the PCB 650, such as the third board 656. The lower surface 650B may be, for example, a surface of a board positioned at the lowermost layer among the plurality of boards of the PCB 650, such as the first board 652. A connector to which the FPCB 680 is coupled may be disposed on the upper surface 650A of the PCB 650.

In an embodiment, a height of the upper surface 650A may be formed to be higher than a height of a vertical end of the first wall structure 560. For example, a distance from the plane 510A to the upper surface 650A, which is the height of the upper surface 650A, may be a first distance a1. A distance from the plane 510A to the vertical end of the first wall structure 560 may be a second distance a2 smaller than the first distance a1. Accordingly, coupling between the PCB 650 and the FPCB 680 and formation of a bent section of the FPCB 680 may not be interfered with by the first wall structure 560.

In an embodiment, the second housing part 521 may include a guide wall 660 for guiding the FPCB 680. The guide wall 660 may protrude from the plane 510A of the supporting plate 510. The FPCB 680 may extend between the guide wall 660 and the first wall structure 560. The guide wall 660 may be formed to have substantially the same height as the first distance a1, which is the height of the upper surface 650A of the PCB 650, but is not limited thereto.

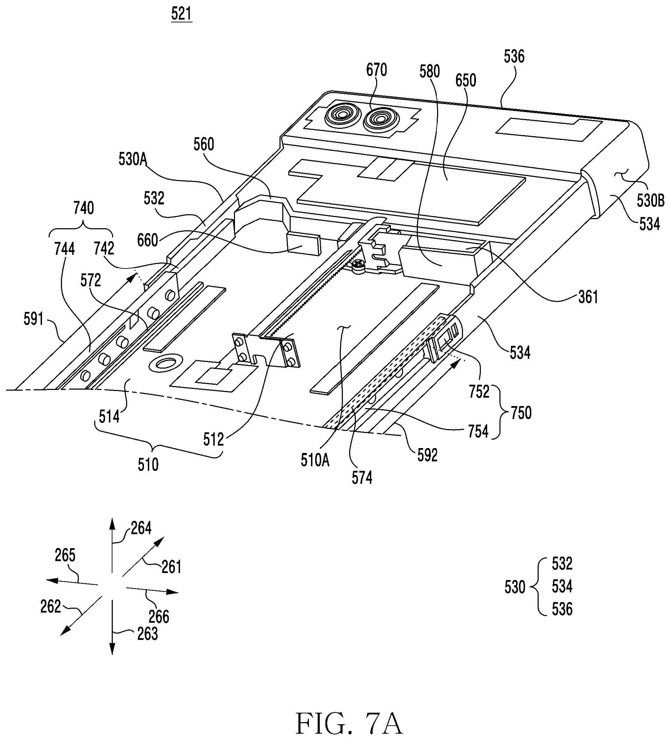

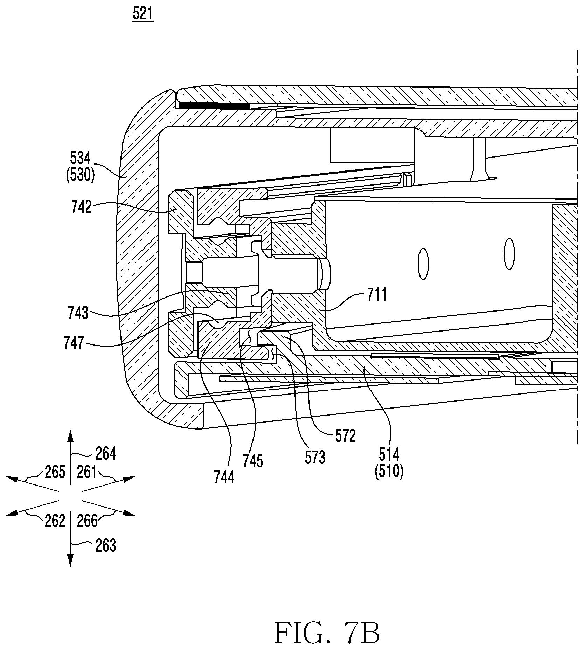

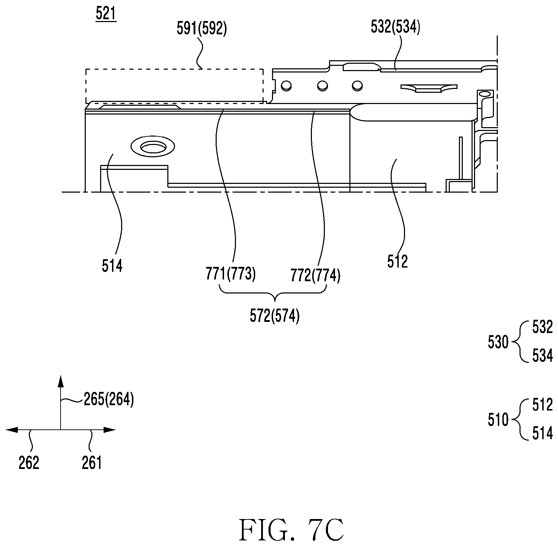

FIG. 7A is an exemplary perspective view illustrating a second housing part to which a rail structure is coupled, according to an embodiment. FIG. 7B is an exemplary cross-sectional view illustrating a rail structure and a second wall structure, according to an embodiment. FIG. 7C is an exemplary diagram illustrating a second wall structure of a second housing part according to an embodiment.

Referring to FIGS. 7A and 7B, an electronic device 200 according to an embodiment may include rail structures 740 and 750 (e.g., the rails 313a of FIG. 3A) coupled to a second housing part 521.

For example, a first rail structure 740 may include a first fixed rail 742 and a first moving rail 744. The first fixed rail 742 may be fixedly coupled to an end portion (e.g., an end portion in a second direction 262) of a first sidewall 532. The first moving rail 744 may be movably coupled to the first fixed rail 742. For example, the first moving rail 744 may be slidably coupled with respect to the first fixed rail 742 in conjunction with sliding of the second housing part 521. For example, a first protrusion 743 extending along a sliding direction (e.g., a first direction 261) of the second housing part 521 may be formed in the first fixed rail 742, and a first groove 747 accommodating the first protrusion 743 of the first fixed rail 742 may be formed in the first moving rail 744. The first moving rail 744 may move along a path guided by the first protrusion 743 of the first fixed rail 742 and the first groove 747 coupled thereto. In an embodiment, in order not to interfere with sliding of the first moving rail 744, a first opening area 591 may be formed in a first side 530A of the second housing part 521. For example, the first opening area 591 may be formed in the first side 530A (or the first sidewall 532) such that the first side 530A (or the first sidewall 532) does not overlap the first moving rail 744.

For example, a second rail structure 750 may include a second fixed rail 752 and a second moving rail 754. The second fixed rail 752 may be fixedly coupled to an end portion (e.g., an end portion in the second direction 262) of a second sidewall 534. The second moving rail 754 may be movably coupled to the second fixed rail 752. For example, the second moving rail 754 may be slidably coupled with respect to the second fixed rail 752 in conjunction with the sliding of the second housing part 521. For example, although not illustrated, a protrusion (e.g., the first protrusion 743) extending along the sliding direction (e.g., the first direction 261) of the second housing part 521 may be formed in the second fixed rail 752, and a groove (e.g., the first groove 747) accommodating the protrusion of the second fixed rail 752 may be formed in the second moving rail 754. The second moving rail 754 may move along a path guided by the protrusion of the second fixed rail 752 and the groove coupled thereto. In an embodiment, in order not to interfere with sliding of the second moving rail 754, a second opening area 592 may be formed in a second side 530B of the second housing part 521. For example, the second opening area 592 may be formed in the second side 530B (or the second sidewall 534) such that the second side 530B (or the second sidewall 534) does not overlap the second moving rail 754.

Although not illustrated, the first moving rail 744 and the second moving rail 754 may be fixedly coupled to a first housing part (e.g., the first housing part 210 of FIG. 4B). By the first rail structure 740 and the second rail structure 750, stable sliding of the second housing part 521 with respect to the first housing part 210 may be possible.

In an embodiment, the first fixed rail 742 or the second fixed rail 752 may be referred to as a slide fixing support. The first moving rail 744 or the second moving rail 754 may be referred to as a slide moving support. In addition, since the first fixed rail 742 and the first moving rail 744 are relatively movable, the first fixed rail 742 may be referred to as a first moving rail (or the slide moving support), and the first moving rail 744 may be referred to as a first fixed rail (or the slide fixing support). In addition, since the second fixed rail 752 and the second moving rail 754 are relatively movable, the second fixed rail 752 may be referred to as the first moving rail (or the slide moving support), and the second moving rail 754 may be referred to as a second fixed rail (or the slide fixing support). The first moving rail 744 and the second moving rail 754 may be referred to as a pair of moving rails (or fixed rails) or a pair of sliding moving supports (or slide fixing supports). The first fixed rail 742 and the second fixed rail 752 may be referred to as a pair of fixed rails (or moving rails) or a pair of sliding fixing supports (or slide moving supports).

Referring to FIG. 7B, in an embodiment, the first moving rail 744 may be movably coupled with respect to a first wall 572. For example, the first moving rail 744 may be slidably coupled with respect to the first wall 572 in conjunction with the sliding of the second housing part 521. For example, the first wall 572 may guide movement of the first moving rail 744. For example, the first wall 572 may be accommodated in a second groove 745 of the first moving rail 744 extending along the sliding direction (e.g., the first direction 261) of the second housing part 521. In addition, a part of the first moving rail 744 may be accommodated in a groove 573 of the first wall 572 extending along the sliding direction of the second housing part 521. The second groove 745 of the first moving rail 744 in which the first wall 572 is accommodated may be positioned on an opposite side of the first groove 747 in which the first protrusion 743 of the first fixed rail 742 is accommodated. As the first fixed rail 742 and the first wall 572 guide movement of the first moving rail 744 on both sides of the first moving rail 744, the second housing part 521 may slide more stably.

In an embodiment, the second moving rail 754 may be movably coupled with respect to a second wall 574. For example, the second moving rail 754 may be slidably coupled with respect to the second wall 574 in conjunction with the sliding of the second housing part 521. For example, the second wall 574 may guide movement of the second moving rail 754. For example, the second wall 574 may be accommodated in another groove (e.g., the second groove 745) of the second moving rail 754 extending along the sliding direction (e.g., the first direction 261) of the second housing part 521. A part of the second moving rail 754 may be accommodated in another groove (e.g., the groove 573) of the second wall 574 extending along the sliding direction of the second housing part 521. The another groove of the second moving rail 754 in which the second wall 574 is accommodated may be positioned on an opposite side of the groove in which the protrusion of the second fixed rail 752 is accommodated. As the second fixed rail 752 and the second wall 574 guide movement of the second moving rail 754 on both sides of the second moving rail 754, the second housing part 521 may slide more stably.

Referring to FIG. 7C, the first wall 572 according to an embodiment may extend along the sliding direction (e.g., the first direction 261) of the second housing part 521. The first wall 572 may be positioned at a periphery portion of a supporting plate 510. The first wall 572 may include a section overlapping the first sidewall 532. In various embodiments of the present disclosure, "overlapping" means only that at least a part of a component is positioned in a boundary of another component when projected from a specific point of view, and unless otherwise mentioned, is not interpreted that they are in physical contact with or spaced apart from each other.

For example, the first wall 572 may include a first section 771 protruding on a second portion 514 of the supporting plate 510, and a second section 772 extending from the first section 771 and protruding on a first portion 512 of the supporting plate 510. The first section 771 may overlap the first opening area 591. The second section 772 may overlap the first sidewall 532, and the first section 771 may not overlap the first sidewall 532. For example, the second section 772 of the first wall 572 may overlap the first sidewall 532 when viewed in a fifth direction 265. Referring to FIG. 7A together, in an embodiment, the first rail structure 740 may be partially positioned between the first sidewall 532 and the second section 772 of the first wall 572. For example, the first fixed rail 742 may be disposed on an inner surface of the first sidewall 532 facing the first wall 572. For example, the first fixed rail 742 disposed on the inner surface of the first sidewall 532 may be coupled to the first sidewall 532 through a screw passing through the first sidewall 532. In an embodiment, as the first wall 572 extends beyond the second portion 514 of the supporting plate 510 to the first portion 512 such that it overlaps the first sidewall 532, a sufficient increase amount in rigidity required to adjust vibration transmission characteristics may be secured. In addition, as the first wall 572 extends beyond the second portion 514 of the supporting plate 510 to the first portion 512 such that it overlaps the first sidewall 532, a length of a path along which the first rail structure 740 is guided by the first wall 572 may be improved, and stability of sliding of the second housing part 521 guided by the first rail structure 740 may be improved.

The second wall 574 according to an embodiment may extend along the sliding direction (e.g., the first direction 261) of the second housing part 521. The second wall 574 may be positioned at the periphery portion of the supporting plate 510. The second wall 574 may include a section overlapping the second sidewall 534. For example, the second wall 574 may include a first section 773 protruding on the second portion 514 of the supporting plate 510, and a second section 774 extending from the first section 773 and protruding on the first portion 512 of the supporting plate 510. The first section 773 may overlap the second opening area 592. The second section 774 may overlap the second sidewall 534, and the first section 773 may not overlap the second sidewall 534. For example, the second section 774 of the second wall 574 may overlap the second sidewall 534 when viewed in a fourth direction 264. Referring to FIG. 7A together, in an embodiment, the second rail structure 750 may be partially positioned between the second sidewall 534 and the second section 774 of the second wall 574. For example, the second fixed rail 752 may be disposed on an inner surface of the second sidewall 534 facing the second wall 574. For example, the second fixed rail 752 disposed on the inner surface of the second sidewall 534 may be coupled to the second sidewall 534 through a screw passing through the second sidewall 534. In an embodiment, as the second wall 574 extends beyond the second portion 514 of the supporting plate 510 to the first portion 512 such that it overlaps the second sidewall 534, an increase amount in rigidity required to adjust vibration transmission characteristics may be secured. In addition, as the second wall 574 extends beyond the second portion 514 of the supporting plate 510 to the first portion 512 such that it overlaps the second sidewall 534, a length of a path along which the second rail structure 750 is guided by the second wall 574 may be improved, and stability of sliding of the second housing part 521 guided by the second rail structure 750 may be improved.

In an embodiment, the first rail structure 740 and/or the second rail structure 750 may be referred to as a linear motion guide for guiding sliding movement of the second housing part 521 with respect to the first housing part (e.g., the first housing part 210 of FIG. 4B).

In an embodiment, the first fixed rail 742 and the first moving rail 744 of the first rail structure 740 may be referred to as a first slide fixing support and a first slide moving support, a first guide rail and a first guide block, a first guide body and a first guide head, a first guide fixing portion and a first guide moving portion, or a first guide portion and a second guide portion.

In an embodiment, the second fixed rail 752 and the second moving rail 754 of the second rail structure 750 may be referred to as a second slide fixing support and a second slide moving support, a second guide rail and a second guide block, a second guide body and a second guide head, a second guide fixing portion and a second guide moving portion, or a third guide portion and a fourth guide portion.

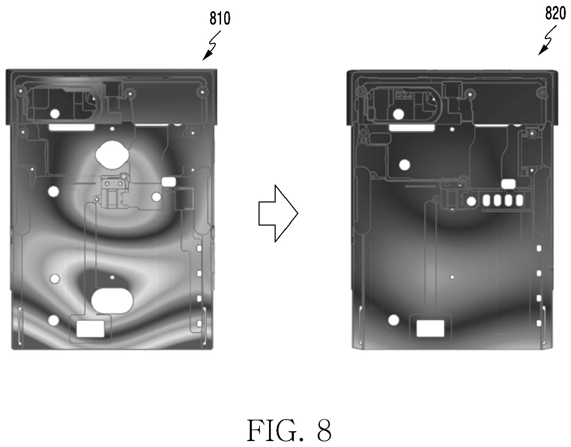

FIG. 8 is a diagram illustrating vibration characteristics of a second housing part. An example 810 of FIG. 8 illustrates vibration characteristics of a second housing part according to a comparative embodiment, and an example 820 of FIG. 8 illustrates vibration characteristics of a second housing part 521 according to an embodiment. The second housing part according to the comparative embodiment of the example 810 may not include wall structures for preventing vibration of a motor structure from being amplified as noise, for example, a first wall structure 560, a first wall 572, a second wall 574, and a fourth wall 580, and the second housing part 521 according to the embodiment of the example 820 may include the first wall structure 560, the first wall 572, the second wall 574, and the fourth wall 580.

Referring to FIG. 8, in a case of the example 820, vibration displacement may be decreased overall, compared to the example 810. Referring to FIG. 5A, as rigidity is improved through the first wall structure 560 around a motor structure 361, vibration displacement of a supporting plate 510 on which the motor structure 361 is disposed may be decreased, and vibration transmitted from the motor structure 361 to a lower end portion (e.g., a second portion 514) of the supporting plate 510 may be decreased. In addition, due to the first wall 572 and the second wall 574, shaking of the second portion 514 of the supporting plate 510 may be decreased. Accordingly, noise amplified due to the vibration may be decreased.

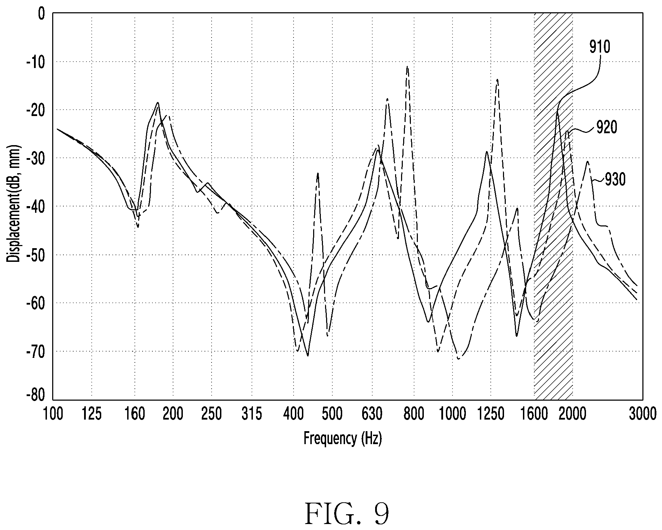

FIG. 9 is a graph illustrating vibration characteristics according to frequency of a second housing part according to an embodiment. A graph 910 of FIG. 9 illustrates vibration characteristics according to frequency of a second housing part according to a comparative example, a graph 920 illustrates vibration characteristics of a second housing part 521 including a fourth wall 580, and a graph 930 illustrates vibration characteristics of the second housing part 521 including a first wall structure 560, a first wall 572, and a second wall 574 in addition to the fourth wall 580.

Referring to FIG. 9, in the graph 920, displacement of vibration may be decreased, compared to the graph 910, and may be shifted rightward. In the graph 930, displacement of vibration may be decreased, compared to the graph 920, and may be shifted rightward. Not only the displacement of vibration may be decreased, but also the vibration characteristics may be shifted in a specific direction, thereby reducing the degree of noise amplification. For example, a motor structure 361 may have operating frequency of approximately 1,600 Hz to approximately 2,000 Hz. As peaks of the graphs 910 and 920 may be overlaid within an operating frequency range of the motor structure 361, a degree to which noise is amplified due to vibration transmitted by the motor structure 361 may be increased. In contrast, as a peak of the graph 930 is positioned outside the operating frequency range of the motor structure 361, resonance of the second housing part 521 due to the vibration transmitted from the motor structure 361 may be reduced or prevented. Accordingly, noise generated as the vibration transmitted from the motor structure 361 is amplified by the second housing part 521 may be reduced or prevented. It may be because natural frequency of the second housing part 521 is increased as rigidity of the second housing part 521 is improved by the first wall structure 560, the first wall 572, the second wall 574, and the fourth wall 580.

Alternatively to the above-described wall structures, in order to reduce vibration displacement and/or shift vibration characteristics of the second housing part 521, a material of the second housing part 521 may be changed or a mass thereof may be increased. However, changing the material may change other characteristics (e.g., antenna characteristics) of an electronic device 200 and thus may not be suitable, and increasing the mass may reduce portability of the electronic device 200 and thus may not be suitable.

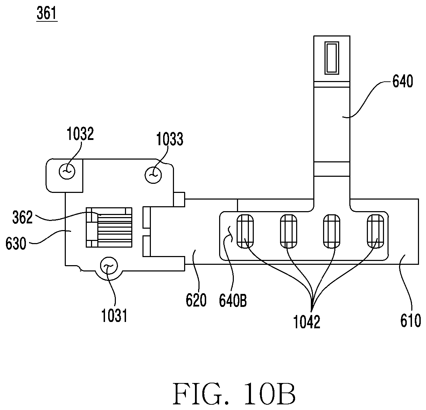

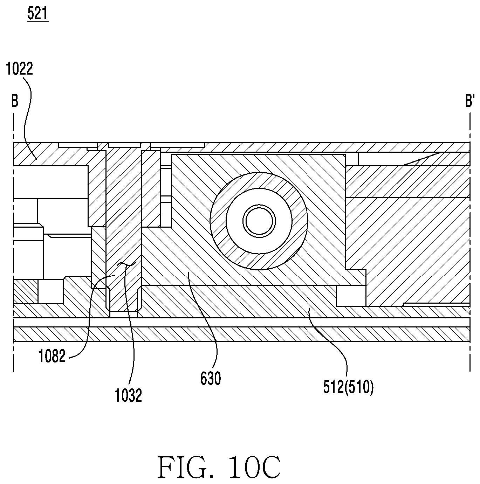

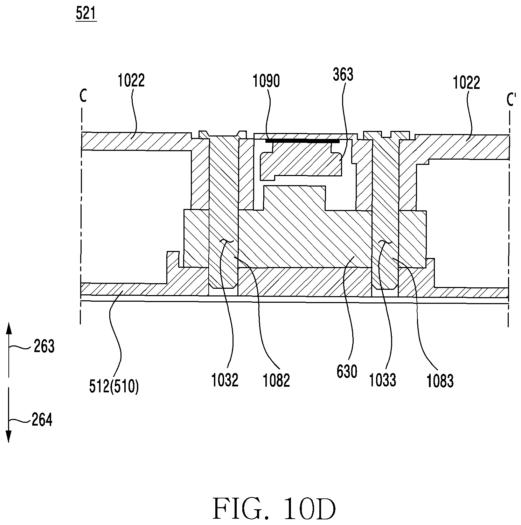

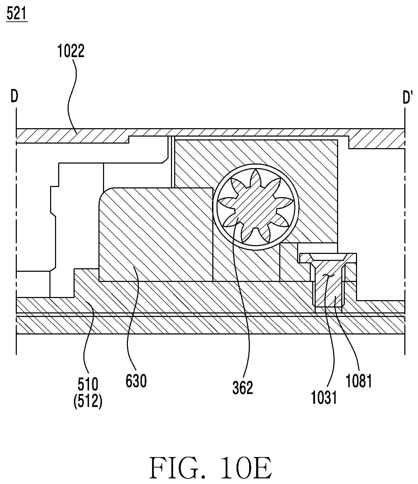

FIG. 10A is an exemplary top plan view of a second housing part according to an embodiment. FIG. 10B is an exemplary diagram illustrating a motor structure according to an embodiment. FIG. 10C is an exemplary cross-sectional view cut along line B-B' of FIG. 10A. FIG. 10D is an exemplary cross-sectional view cut along line C-C' of FIG. 10A. FIG. 10E is an exemplary cross-sectional view cut along line D-D' of FIG. 10A.

In FIG. 10A, a rotational axis A1 of a motor structure 361 and a moving axis A2 of a rack gear 363 are illustrated together. The rotational axis A1 of the motor structure 361 may be substantially perpendicular to a sliding direction (e.g., a first direction 261) of a second housing part 521, and the moving axis A2 of the rack gear 363 may be substantially parallel to the sliding direction (e.g., the first direction 261) of the second housing part 521.

Referring to FIGS. 10A and 10B, in an embodiment, a plurality of fastening holes for fixedly coupling the motor structure 361 may be formed in the second housing part 521. For example, a first fastening hole 1051, a second fastening hole 1052, and a third fastening hole 1053 may be formed in a first portion 512 of a supporting plate 510. In an embodiment, each of the first fastening hole 1051, the second fastening hole 1052, and the third fastening hole 1053 may at least partially pass through the supporting plate 510.

For example, the first fastening hole 1051 and the second fastening hole 1052 may be arranged with respect to the rotational axis A1 (e.g., a direction parallel to a fifth direction 265) of the motor structure 361. For example, the rotational axis A1 of the motor structure 361 may pass a portion between the first fastening hole 1051 and the second fastening hole 1052. For example, the first fastening hole 1051 may be positioned in a direction (e.g., a second direction 262) with respect to the rotational axis A1 of the motor structure 361, and the second fastening hole 1052 may be positioned in an opposite direction (e.g., the first direction 261) to the direction with respect to the rotational axis A1 of the motor structure 361. In an embodiment, the first fastening hole 1051 may overlap the rack gear 363 or the moving axis A2 of the rack gear 363. For example, when the second housing part 521 is viewed from above (e.g., when viewed in a third direction 263), the first fastening hole 1051 may overlap the rack gear 363 or the moving axis A2 of the rack gear 363.

For example, the first fastening hole 1051 and the third fastening hole 1053 may be arranged with respect to the rotational axis A1 of the motor structure 361. For example, the rotational axis A1 of the motor structure 361 may pass a portion between the first fastening hole 1051 and the third fastening hole 1053. For example, the first fastening hole 1051 may be positioned in the direction (e.g., the second direction 262) with respect to the rotational axis A1 of the motor structure 361, and the third fastening hole 1053 may be positioned in the opposite direction (e.g., the first direction 261) to the direction with respect to the rotational axis A1 of the motor structure 361.

For example, the second fastening hole 1052 and the third fastening hole 1053 may be arranged with respect to the moving axis A2 of the rack gear 363. For example, the moving axis A2 of the rack gear 363 may pass a portion between the second fastening hole 1052 and the third fastening hole 1053. For example, the second fastening hole 1052 may be positioned in a direction (e.g., the fifth direction 265) with respect to the moving axis A2 of the rack gear 363, and the third fastening hole 1053 may be positioned in an opposite direction (e.g., a sixth direction 266) to the direction with respect to the moving axis A2 of the rack gear 363.

Referring to FIG. 10B, in an embodiment, a plurality of corresponding holes respectively corresponding to the plurality of fastening holes formed in the second housing part 521 may be formed in a motor bracket 630. For example, a first corresponding hole 1031, a second corresponding hole 1032, and a third corresponding hole 1033 respectively aligned with the first fastening hole 1051, the second fastening hole 1052, and the third fastening hole 1053 of the supporting plate 510 may be formed in the motor bracket 630. The first corresponding hole 1031, the second corresponding hole 1032, and the third corresponding hole 1033 may pass through the motor bracket 630.

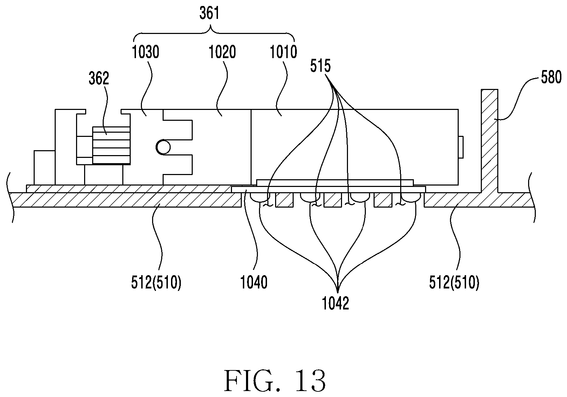

In an embodiment, the motor structure 361 may be positioned on a surface of an FPCB 640. In order to electrically connect coils inside a motor 610, a plurality of connections 1042 may be formed to protrude on another surface 640B opposite to the surface of the FPCB 640. The plurality of connections 1042 may include a conductive terminal or a conductive contact electrically connected to the battery and/or a power management module (e.g., the power management module 188 of FIG. 1) of an electronic device 200 to supply power to the motor 610 or the coils of the motor 610. Although not illustrated in FIG. 10B, as described later with reference to FIG. 13, the plurality of connections 1042 may be at least partially positioned in holes 515 of the supporting plate 510.

Referring to FIGS. 10C, 10D, and 10E, the second housing part 521 according to an embodiment may include a cover 1022 (e.g., the second plate 322 of FIG. 3B) disposed on the supporting plate 510. In an embodiment, the motor bracket 630 may be coupled to the supporting plate 510 through a plurality of screws that pass through the motor bracket 630 or pass through the motor bracket 630 and the cover 1022 and are fastened to the plurality of fastening holes of the supporting plate 510.

For example, referring to FIG. 10C, the cover 1022, the motor bracket 630, and the supporting plate 510 may be coupled to each other through a screw 1082 that passes through the cover 1022 and the second corresponding hole 1032 of the motor bracket 630 and is fastened to the second fastening hole 1052 of the supporting plate 510.

For example, referring to FIG. 10D, the cover 1022, the motor bracket 630, and the supporting plate 510 according to an embodiment may be coupled to each other through a screw 1083 that passes through the cover 1022 and the third corresponding hole 1033 of the motor bracket 630 and is fastened to the third fastening hole 1053 of the supporting plate 510.

For example, referring to FIG. 10E, the motor bracket 630 and the supporting plate 510 according to an embodiment may be coupled to each other through a screw 1081 that passes through the first corresponding hole 1031 of the motor bracket 630 and is fastened to the first fastening hole 1051 of the supporting plate 510.

Referring again to FIG. 10D, in an embodiment, the second housing part 521 may include a lubrication member 1090 disposed between the rack gear 363 and the cover 1022. For example, the lubrication member 1090 may be positioned in a gap between the rack gear 363 and the cover 1022. For example, the lubrication member 1090 may be disposed between a back surface of the cover 1022 facing the rack gear 363 and a teeth root of the rack gear 363. For example, the lubrication member 1090 may be attached on the back surface of the cover 1022 and/or on the teeth root of the rack gear 363. The lubrication member 1090 may reduce or prevent flow according to a thickness direction (e.g., the third direction 263 or a fourth direction 264) of the rack gear 363 when the rack gear 363 moves. In addition, it may reduce or prevent vibration and/or noise caused by friction between the rack gear 363 and the cover 1022 when the rack gear 363 moves. The lubrication member 1090 may include, for example, a Teflon tape, but is not limited thereto.

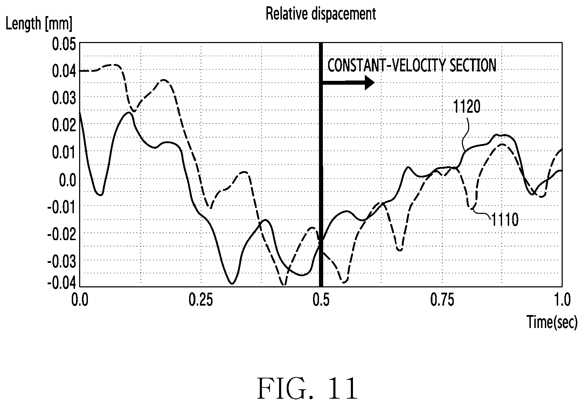

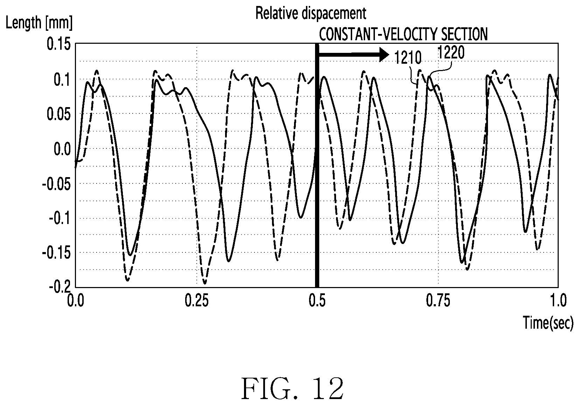

In an embodiment, through the first fastening hole 1051, the second fastening hole 1052, and the third fastening hole 1053 arranged with respect to the rotational axis A1 of the motor structure 361 and the moving axis A2 of the rack gear 363, a vibration amplitude of the rack gear 363 may be decreased when force is transmitted from a pinion gear 362 connected to a reducer 620 of the motor structure 361 to the rack gear 363. For example, through the first fastening hole 1051 and the second fastening hole 1052 positioned with the rotational axis A1 of the motor structure 361 therebetween, vibration of the motor structure 361 and the rack gear 363 to which a force of the motor structure 361 is transmitted with respect to the rotational axis A1 may be reduced or prevented. For example, through the first fastening hole 1051 and the third fastening hole 1053 positioned with the rotational axis A1 of the motor structure 361 therebetween, the vibration of the motor structure 361 and the rack gear 363 to which the force of the motor structure 361 is transmitted with respect to the rotational axis A1 may be reduced or prevented. For example, through the second fastening hole 1052 and the third fastening hole 1053 positioned with the moving axis A2 of the rack gear 363 therebetween, vibration of the motor structure 361 and the rack gear 363 to which a force of the motor structure 361 is transmitted with respect to the moving axis A2 may be reduced or prevented. Accordingly, due to a decrease in the vibration amplitude of the motor structure 361 and the rack gear 363, not only noise generated as vibration is amplified by the second housing part 521 may be reduced, but also force transfer efficiency of the motor structure 361 for sliding of the second housing part 521 may be improved. The above-described effect in which vibration displacement is reduced is exemplified in descriptions of FIGS. 11 and 12.

FIGS. 11 and 12 are diagrams illustrating vibration displacement of a second housing part over time. In description of FIGS. 11 and 12, the above-described drawings may be referenced. In FIGS. 11 and 12, a motor structure 361 may operate in a constant-velocity section from after approximately 0.5 seconds.

FIG. 11 is a diagram illustrating a vibration displacement according to an X-axis (e.g., the rotational axis A1 of FIG. 10A) of a second housing part 521 when the motor structure 361 operates. A graph 1120 of FIG. 11 illustrates vibration characteristics of the second housing part 521 having a fastening structure through screws 1081, 1082, and 1083 between the motor structure 361 and the second housing part 521 exemplified in the descriptions of FIGS. 10A to 10E, according to an embodiment. A graph 1110 illustrates vibration characteristics of a second housing part to which a motor structure is fixedly coupled through screws having arrangement different from the screws 1081, 1082, and 1083 in a comparative example.

Referring to FIG. 11, in the constant-velocity section of the motor structure 361, a vibration displacement according to the X-axis of the graph 1120 may be decreased compared to a vibration displacement according to the X-axis of the graph 1100. For example, the vibration displacement according to the X-axis of the graph 1120 may be decreased by approximately 22% compared to the vibration displacement according to the X-axis of the graph 1100.

FIG. 12 is a diagram illustrating a vibration displacement according to a Y-axis (e.g., the moving axis A2 of FIG. 10A) of the second housing part 521 when the motor structure 361 operates. A graph 1220 of FIG. 12 illustrates the vibration characteristics of the second housing part 521 having the fastening structure through the screws 1081, 1082, and 1083 between the motor structure 361 and the second housing part 521 exemplified in the descriptions of FIGS. 10A to 10E, according to an embodiment. A graph 1210 illustrates the vibration characteristics of the second housing part to which the motor structure is fixedly coupled through the screws having arrangement different from the screws 1081, 1082, and 1083 in the comparative example.

Referring to FIG. 12, in the constant-velocity section of the motor structure 361, a vibration displacement according to the Y-axis of the graph 1120 may be decreased compared to a vibration displacement according to the Y-axis of the graph 1100. For example, the vibration displacement according to the Y-axis of the graph 1120 may be decreased by approximately 7% compared to the vibration displacement according to the Y-axis of the graph 1100.

FIG. 13 is an exemplary diagram illustrating a motor structure disposed on a second housing part according to an embodiment.

Referring to FIG. 13, in an embodiment, a motor structure 361 may include a motor (or a motor core) 1010 (e.g., the motor 610 of FIG. 6A), a reducer 1020 (e.g., the reducer 620 of FIG. 6A) coupled to the motor 610, a motor bracket 1030 (e.g., the motor bracket 630 of FIG. 6A) supporting the motor 1010 and the reducer 1020, and an FPCB 1040 (e.g., the FPCB 640 of FIG. 6A) electrically connecting the motor structure 361 and a PCB (e.g., the PCB 650 of FIG. 6C).

In an embodiment, the motor structure 361 may be disposed on a supporting plate 510 of a second housing part 521. For example, the motor structure 361 may be disposed on the supporting plate 510 such that the FPCB 1040 faces the supporting plate 510. A plurality of connections 1042 protruding from the FPCB 1040 may be at least partially accommodated in holes 515 of the supporting plate 510. Accordingly, by disposing the FPCB 1040 of the motor structure 361 on the supporting plate 510, a mounting space of the second housing part 521 may be saved.

An electronic device (e.g., the electronic device 200 of FIG. 2A) according to an embodiment may include a first housing part (e.g., the first housing part 210 of FIG. 3A), a second housing part (e.g., the second housing part 521 of FIG. 5A) slidably coupled with respect to the first housing part in a first direction (e.g., the first direction 261 of FIG. 5A) and including a first side (e.g., the first side 530A of FIG. 5A) and a second side (e.g., the second side 530B of FIG. 5A) formed along the first direction, a motor (e.g., the motor 610 of FIG. 6A) disposed on a first plane (e.g., the plane 510A of FIG. 5A) substantially perpendicular to at least one of the first side and the second side between the first side and the second side in the second housing part and having a rotational axis in a second direction (e.g., the fifth direction 265 of FIG. 5A) perpendicular to the first direction, a first wall (e.g., the first wall 561 of FIG. 6B) formed around the motor substantially parallel to the second direction and disposed substantially perpendicular to the first plane, and at least one second wall (e.g., the second wall 562 of FIG. 6B) extending from the first wall in the second direction. Accordingly, noise that may be generated as vibration of the motor is transmitted to the second housing part may be decreased.

In an embodiment, the electronic device may include at least one third wall (e.g., the third wall 563 of FIG. 6B) extending from the first wall or the at least one second wall in a direction different from the second direction.

In an embodiment, the first wall, the at least one second wall, and the at least one third wall may be connected to each other and may cross the first plane of the second housing part.

In an embodiment, the motor may provide a driving force rotating with respect to the rotational axis such that the second housing part moves with respect to the first housing part.

In an embodiment, the electronic device may include a wall structure (e.g., the first wall structure 560 of FIG. 5A) extending between the first side and the second side such that vibration of the second housing part caused by the driving of the motor is mitigated. The wall structure may include the first wall and the at least one second wall.

In an embodiment, the electronic device may include a fourth wall (e.g., the fourth wall 580 of FIG. 6A) extending from the first wall such that at least a part of the motor is covered together with the first wall.

In an embodiment, the electronic device may include a printed circuit board (e.g., the printed circuit board 650 of FIG. 6A), a fifth wall (e.g., the first section 562-1 of FIG. 6B) spaced apart from the first wall, and a flexible printed circuit board (e.g., the FPCB 640 of FIG. 6A) electrically connecting the motor to the printed circuit board and disposed between the first wall and the fifth wall.

In an embodiment, the electronic device may include a sixth wall (e.g., the second section 562-2 of FIG. 6B) extending from the first wall to the fifth wall. The sixth wall may be formed to have a lower height than at least one of the first wall and the fifth wall. The flexible printed circuit board may extend above the sixth wall.

In an embodiment, the electronic device may include a seventh wall (e.g., the third section 562-3 of FIG. 6B) spaced apart from the first wall, a pinion gear (e.g., the pinion gear 362 of FIG. 10B) rotating in conjunction with the driving of the motor, and a rack gear (e.g., the rack gear 363 of FIG. 6A) that moves along the first direction between the first wall and the seventh wall in conjunction with the rotation of the pinion gear.

In an embodiment, the electronic device may include an eighth wall (e.g., the second section 562 of FIG. 6B) extending from the first wall to the seventh wall, and the eighth wall may be formed to have a lower height than at least one of the first wall and the seventh wall, and the rack gear may move along the first direction above the eighth wall.

In an embodiment, the at least one second wall may include the fifth wall, the sixth wall, the seventh wall, and the eighth wall.

In an embodiment, the electronic device may include a motor bracket (e.g., the motor bracket 630 of FIG. 10B) supporting the motor and coupled to the first plane of the second housing part, and the motor bracket may include a first portion positioned in the first direction with respect to the rotational axis of the motor and a second portion positioned in an opposite direction to the first direction with respect to the rotational axis. The electronic device may include a first screw (e.g., the screw 1081 of FIG. 10E) passing through the first portion of the motor bracket and fastened to the second housing part, a second screw (e.g., the screw 1082 of FIG. 10D) passing through the second portion of the motor bracket and fastened to the second housing part, and a third screw (e.g., the screw 1083 of FIG. 10D) passing through the second portion of the motor bracket and fastened to the second housing part and spaced apart from the second screw in the second direction.

In an embodiment, the electronic device may include a cover (e.g., the cover 1022 of FIG. 10C) coupled to the second housing part to overlap the motor bracket. At least one of the first screw, the second screw, or the third screw may pass through the cover and the motor bracket and may be fastened to the second housing part.

In an embodiment, the electronic device may include a pinion gear rotating in conjunction with the driving of the motor, and a rack gear that is coupled to be fixed to the first housing part and in conjunction with the rotation of the pinion gear such that it moves in the first direction. The first screw may overlap a moving path of the rack gear.

In an embodiment, it may include a lubrication member (e.g., the lubrication member 1090 of FIG. 10D) disposed between the cover and the rack gear.

In an embodiment, the electronic device may include a pair of slide fixing supports (e.g., the first and second moving rails 742 and 752 of FIG. 7A) coupled to be fixed to the first housing part, a pair of slide moving supports (e.g., the first and second fixing rails 744 and 754 of FIG. 7A) respectively coupled to the first side and the second side of the second housing part, and slidably coupled with respect to the pair of fixing supports in conjunction with sliding of the second housing part, and a pair of walls (e.g., the first and second walls 572 and 574 of FIG. 7A) formed on the first plane. The first side and the second side may have opening areas (e.g., the first and second opening areas 591 and 592 of FIG. 7A) such that the first side and the second side do not overlap the pair of slide fixing supports. The pair of walls may overlap the opening areas along the first direction.

In an embodiment, the opening areas may include a first opening area (e.g., the first opening area 591 of FIG. 7A) of the first side and a second opening area (e.g., the second opening area 592 of FIG. 7A) of the second side, and a first wall (e.g., the first wall 572 of FIG. 7C) of the pair of walls may include a first section (e.g., the first section 771 of FIG. 7C) that overlaps the first opening area and a second section (e.g., the second section 772 of FIG. 7C) extending from the first section to overlap the first side. A second wall (e.g., the second wall 574 of FIG. 7C) of the pair of walls may include a first section (e.g., the first section 773 of FIG. 7C) that overlaps the second opening area and a second section (e.g., the second section 774 of FIG. 7C) extending from the first section of the second wall to overlap the second side.

In an embodiment, the pair of walls may be slidably coupled to the pair of slide fixing supports.

In an embodiment, the electronic device may include a flexible printed circuit board positioned between the motor and the first plane of the second housing part, and the flexible printed circuit board may include one or more connections (e.g., the connections 1042 of FIG. 13) that protrude from a surface of the flexible printed circuit board and are electrically connected to the motor, one or more recesses or through holes (e.g., the through holes 1042 of FIG. 13) positioned in the first plane may be formed in the second housing part, and the one or more connections may be at least partially accommodated in the one or more recesses or through holes.

An electronic device (e.g., the electronic device 200 of FIG. 2A) according to an embodiment may include a first housing part (e.g., the first housing part 210 of FIG. 3A), a second housing part (e.g., the second housing part 521 of FIG. 5A) slidably coupled with respect to the first housing part in a first direction (e.g., the first direction 261 of FIG. 5A) and including a first side (e.g., the first side 530A of FIG. 5A) and a second side (e.g., the second side 530B of FIG. 5A) which are formed along the first direction, a motor (e.g., the motor structure 361 of FIG. 5A) disposed on a first plane (e.g., the plane 510A of FIG. 5A) substantially perpendicular to the first side and the second side in the second housing part and having a rotational axis in a second direction perpendicular to the first direction, a pair of slide fixing supports (e.g., the first and second moving rails 742 and 752 of FIG. 7A) coupled to be fixed to the first housing part, a pair of slide moving supports (e.g., the first and second fixing rails 744 and 754 of FIG. 7A) respectively coupled to the first side and the second side of the second housing part, and slidably coupled with respect to the pair of fixing supports in conjunction with sliding of the second housing part, and a pair of walls (e.g., the first and second walls 572 and 574 of FIG. 7A) formed on the first plane. The first side and the second side may have opening areas (e.g., the first and second opening areas 591 and 592 of FIG. 7A) such that the first side and the second side do not overlap the pair of slide fixing supports. The pair of walls may overlap the opening areas along the first direction. Accordingly, noise that may be generated as vibration of the motor is transmitted to the second housing part may be decreased.

In an embodiment, the opening areas may include a first opening area (e.g., the first opening area 591 of FIG. 7A) of the first side and a second opening area (e.g., the second opening area 592 of FIG. 7A) of the second side, and a first wall (e.g., the first wall 572 of FIG. 7C) of the pair of walls may include a first section (e.g., the first section 771 of FIG. 7C) that overlaps the first opening area and a second section (e.g., the second section 772 of FIG. 7C) extending from the first section to overlap the first side. A second wall (e.g., the second wall 574 of FIG. 7C) of the pair of walls may include a first section (e.g., the first section 773 of FIG. 7C) that overlaps the second opening area and a second section (e.g., the second section 774 of FIG. 7C) extending from the first section of the second wall to overlap the second side.

In an embodiment, the pair of walls may be slidably coupled to the pair of fixing supports.

In an embodiment, the pair of walls may be configured to mitigate vibration of the second housing part caused by the driving of the motor.

In an embodiment, an electronic device (e.g., the electronic device 200 of FIG. 2A) may include a first housing part (e.g., the first housing part 210 of FIG. 2A), a second housing part (e.g., the second housing part 521 of FIG. 5A) that includes a supporting plate (e.g., the supporting plate 510 of FIG. 5A) having a first side (e.g., the first side 530A of FIG. 5A) and a second side (e.g., the second side 530B of FIG. 5A) opposite to each other, a first sidewall (e.g., the first sidewall 532 of FIG. 5A) of the first side, and a second sidewall (e.g., the second sidewall 534 of FIG. 5A) of the second side, and that is slidably coupled (slidably engaged) with respect to the first housing part, and a motor structure (e.g., the motor structure 361 of FIG. 5A) coupled to a bottom surface (e.g., the plane 510A of FIG. 5A) of the supporting plate and configured to provide torque for sliding of the second housing part. The first sidewall and the second sidewall may be thicker than the supporting plate and protrude from the bottom surface of the supporting plate, the second housing part may include a wall (e.g., the first wall structure 560 of FIG. 5A) extending vertically from the bottom surface of the supporting plate, and the wall may connect between the first sidewall and the second sidewall across a side of the motor structure. Accordingly, noise that may be generated as vibration of the motor structure is transmitted to the second housing part may be decreased.

In an embodiment, the first sidewall and the second sidewall may be parallel to a sliding direction of the second housing part.

In an embodiment, the wall may include one or more sections substantially perpendicular to the first sidewall and the second sidewall.

In an embodiment, the one or more sections may be substantially parallel to a rotational axis of the motor structure.

In an embodiment, the wall may include a first section, and a second section and a third section respectively connected to both sides of the first section, and a height of the first section may have a lower height than the second section and the third section.

In an embodiment, the electronic device may include a gear structure coupled between the motor structure and the first housing part such that the torque of the motor structure is transmitted, and the gear structure may pass a portion between the second section and the third section.

In an embodiment, the motor structure may include a motor and a reducer coupled to the motor, the gear structure may include a pinion gear coupled to the reducer and a rack gear engaged with the pinion gear and fixedly coupled to the second housing part, and the rack gear may be positioned between the second section and the third section.

In an embodiment, the electronic device may include a flexible printed circuit board electrically connected to the motor structure, and the wall may include a fourth section, and a fifth section and a sixth section respectively connected to both sides of the fourth section, the fourth section may have a lower height than the fifth section and the sixth section, and the flexible printed circuit board may pass a portion between the fifth section and the sixth section.

In an embodiment, the flexible printed circuit board may include a part positioned between the motor structure and the bottom surface of the supporting plate, one or more recesses or through holes positioned in the bottom surface to which the part of the flexible printed circuit board faces may be formed in the supporting plate, the part of the flexible printed circuit board may include one or more connections protruding toward the bottom surface, and the one or more connections may be at least partially accommodated in the one or more recesses or through holes.

In an embodiment, the electronic device may include a printed circuit board disposed on the bottom surface of the supporting plate and positioned on an opposite side of the motor structure with respect to the wall. The printed circuit board may include a lower surface facing the bottom surface and an upper surface opposite to the lower surface, and a height of the upper surface may be higher than a height of a vertical end of the wall.

In an embodiment, the printed circuit board may include a plurality of boards stacked on each other, the plurality of boards may include a top board and one or more remaining boards below the top board, the top board may include a first surface and a second surface opposite to the first surface and facing the one or more remaining boards, and the upper surface may be the first surface of the top board.

In an embodiment, the supporting plate may include a first portion between the first sidewall and the second sidewall, and a second portion extending from the first portion and positioned outside the first sidewall and the second sidewall. The second housing part may include a first wall and a second wall on the second portion, the first wall may be adjacent to the first side of the second portion and extend along the first side of the second portion, and the second wall may be adjacent to the second side of the second portion and extend along the second side of the second portion.

In an embodiment, the electronic device may include a first fixed rail fixedly coupled to an end portion of the first sidewall facing the first side of the second portion, a second fixed rail fixedly coupled to an end portion of the second sidewall facing the second side of the second portion, a first moving rail fixedly coupled to the first housing part and slidably coupled to the first fixed rail and the first wall, and a second moving rail fixedly coupled to the first housing part and slidably coupled to the second fixed rail and the second wall.

In an embodiment, the first wall may further include a section overlapping the first sidewall, and the second wall may further include a section overlapping the second sidewall.

In an embodiment, the motor structure may include a motor and a motor bracket supporting the motor and coupled on the supporting plate. A sliding direction of the second housing part with respect to the first housing part may include a first direction or a second direction opposite to the first direction, and the motor bracket may include a first portion positioned in the first direction with respect to a center of the motor bracket and a second portion positioned in the second direction with respect to the center. The electronic device may include a first screw passing through the first portion of the motor bracket and fastened to the supporting plate, a second screw passing through the second portion of the motor bracket and fastened to the supporting plate, and a third screw passing through the second portion of the motor bracket and fastened to the supporting plate and spaced apart from the second screw in a direction perpendicular to the first direction.

In an embodiment, the electronic device may include a cover coupled to the second housing part to overlap the motor bracket. At least one of the first screw, the second screw, or the third screw may pass through the cover and the motor bracket and may be fastened to the supporting plate of the second housing part.

In an embodiment, the electronic device may include a gear structure coupled between the motor structure and the first housing part such that the torque of the motor structure is transmitted. The gear structure may include a pinion gear coupled to the motor structure and a rack gear moving according to the rotation of the pinion gear and fixedly coupled to the second housing part. The first screw may overlap a moving path of the rack gear.

In an embodiment, the electronic device may include an attached lubrication member positioned between the cover and the rack gear and disposed on the cover.

In an embodiment, the second housing part may include another wall connected to the wall. The another wall may at least partially cover a circumference of the motor structure.

In an embodiment, the another wall, together with the wall, may at least partially cover the circumference of the motor structure.

An electronic device (e.g., the electronic device 200 of FIG. 2A) according to an embodiment may include a first housing part (e.g., the first housing part 210 of FIG. 2A) and a second housing part (e.g., the second housing part 521 of FIG. 5A) slidably coupled (slidably engaged) with respect to the first housing part. The second housing part may include a supporting plate (e.g., the supporting plate 510 of FIG. 5A) including a first side and a second side opposite to the first side, a first sidewall (e.g., the first sidewall 532 of FIG. 5A) of the first side of a first portion (e.g., the first portion 512 of FIG. 5A) of the supporting plate, and a second sidewall (e.g., the second sidewall 534 of FIG. 5A) of the second side of the first portion of the supporting plate. The electronic device may include a motor structure (e.g., the motor structure 361 of FIG. 5A) coupled on the supporting plate and configured to provide torque for sliding of the second housing part. The supporting plate may include a second portion (e.g., the second portion 514 of FIG. 5A) positioned outside the first sidewall and the second sidewall and extending from the first portion toward the first housing part. The second housing part may include a first wall (e.g., the first wall 572 of FIG. 5A) and a second wall (e.g., the second wall 574 of FIG. 5A) on the second portion thinner than the first sidewall and the second sidewall. The first wall may be adjacent to the first side of the second portion and extend along the first side of the second portion. The second wall may be adjacent to the second side of the second portion and extend along the second side of the second portion. Accordingly, noise that may be generated as vibration of the motor structure is transmitted to the second housing part may be decreased.

In an embodiment, the electronic device may include a first fixed rail fixedly coupled to an end portion of the first sidewall facing the first side of the second portion, a second fixed rail fixedly coupled to an end portion of the second sidewall facing the second side of the second portion, a first moving rail fixedly coupled to the first housing part and slidably coupled to the first fixed rail and the first wall, and a second moving rail fixedly coupled to the first housing part and slidably coupled to the second fixed rail and the second wall.

In an embodiment, the first wall may further include a section overlapping the first sidewall, and the second wall may further include a section overlapping the second sidewall.

In an embodiment, the first fixed rail and the first wall may be coupled to both sides of the first moving rail, respectively, and the second fixed rail and the second wall may be coupled to both sides of the second moving rail, respectively.

An electronic device (e.g., the electronic device 200 of FIG. 2A) according to an embodiment may include a first housing part (e.g., the first housing part 210 of FIG. 2A) and a second housing part (e.g., the second housing part 220 of FIG. 2A) slidably coupled to the first housing part. The second housing part may include a bracket (e.g., the second cover 321 of FIG. 3B) including a supporting plate (e.g., the supporting plate 510 of FIG. 5A), a first side exterior wall (e.g., the first sidewall 532 of FIG. 5A) disposed on a first side of the bracket, and a second side exterior wall (e.g., the second sidewall 534 of FIG. 5A) disposed on a second side opposite to the first side of the bracket. The electronic device may further include a motor (e.g., the motor structure 361 of FIG. 5C) embedded in the supporting plate and configured to slide the second housing part with respect to the first housing part. The bracket may further include walls (e.g., the first wall structure 560 of FIG. 5A) extending from the supporting plate and at least partially formed in a direction corresponding to a rotational axis of the motor. The walls may further include a first wall (e.g., the first wall 561 of FIG. 6B) disposed alongside the motor, a second wall (e.g., the third section 562-3 of FIG. 6B) connected to the first side exterior wall, and a third wall (e.g., the second section 563-2 of FIG. 6B) connected to the second side exterior wall. In an embodiment, the first wall may be integrally formed with the second wall. In an embodiment, the second wall may be integrally formed with the third wall. In an embodiment, the first wall may be formed in the direction corresponding to the rotational axis of the motor. In an embodiment, the electronic device may include a PCB (e.g., the PCB 324 of FIG. 3A) and an FPCB (e.g., the FPCB 325 of FIG. 4A) electrically connecting the PCB and the motor, and the first wall may include a recessed portion. The FPCB may be disposed over the recessed portion of the first wall. In an embodiment, the bracket may include a first section (e.g., the first opening area 591 of FIG. 5A) of the first side in which the first side exterior wall is omitted and a second section (e.g., the second opening area 592 of FIG. 5A) of the second side in which the second side exterior wall is omitted. The bracket may further include a first additional wall (e.g., the first wall 572 of FIG. 5A) disposed along the first section on the supporting plate and a second additional wall (e.g., the second wall 574 of FIG. 5A) disposed along the second section on the supporting plate.

An electronic device 200 according to a 1st example may include a first housing part 210, a second housing part 521, slidably coupled with respect to the first housing part 210, including a first side 530A and a second side 530B opposite to the first side 530A, and a motor 610, disposed in the first housing part 210, positioned between the first side 530A and the second side 530B, and configured to slide the second housing part 521 with respect to the first housing part 210. In the 1st example, the second housing part 521 may include a wall structure 560. In the 1st example, the wall structure 560 may include a first portion disposed around the motor 610, and a second portion, extending from the first portion, connected to at least one of the first side 530A and the second side 530B.

In a 2nd example, the second portion of the wall structure 560 according to the 1st example may be connected to both the first side 530A and the second side 530B.

In a 3rd example, the second portion of the wall structure 560 according to the 1st example or the 2nd example may be integrally formed with the first portion of the wall structure 560.

In a 4th example, the second portion of the wall structure 560 according to the 1st example may be connected to the first side 530A between the first side 530A and the second side 530B.

In a 5th example, the second portion of the wall structure 560 according to the 4th example may extend from a part of the first portion of the wall structure 560 to the first side 530A. The wall structure 560 according to the 5th example may include a third portion extending from another part of the first portion of the wall structure 560 to the second side 530B.

In a 6th example, the first portion of the wall structure 560 according to the 5th example may be integrally formed with the second portion of the wall structure 560.

In a 7th example, the first portion of the wall structure 560 according to the 5th example or the 6th example may be integrally formed with the third portion of the wall structure 560.

In an 8th example, the second housing part 521 according to any one of the 1st example to the 7th example may be configured to be slidable in a first direction 261 or 262 with respect to the first housing part 210. The first side 530A and the second side 530B according to the 8th example may be substantially parallel to the first direction 261 or 262.

In a 9th example, the second housing part 521 according to any one of the 1st example to the 7th example may be configured to be slidable in a first direction 261 or 262 with respect to the first housing part 210. The first portion of the wall structure 560 according to the 9th example may be substantially perpendicular to the first direction 261 or 262 and may overlap the motor 610 in the first direction 261 or 262.

In a 10th example, the wall structure 560 according to any one of the 1st example to the 9th example may be configured to mitigate vibration of the second housing part 521 caused by the driving of the motor 610.

In an 11th example, the electronic device 200 according to any one of the 1st example to the 10th example may include a printed circuit board 650, and a flexible printed circuit board 640 electrically connecting the motor 610 to the printed circuit board 650. The wall structure 560 according to the 11th example may include a first wall 561 and a second wall 562-1 spaced apart from the first wall 561. The flexible printed circuit board 640 according to the 11th example may be disposed between the first wall 561 and the second wall 562-1.

In a 12th example, the wall structure 560 according to the 11th example may include a third wall 562-2 extending from the first wall 561 to the second wall 562-1 below the printed circuit board 650.

In a 13th example, the first wall 561, the second wall 562-1, and the third wall 562-2 according to the 12th example may be included in the first portion of the wall structure 560.

In a 14th example, the second housing part 521 according to any one of the 1st example to the 13th example may be configured to slide in a first direction 261 or 262 with respect to the first housing part 210. The electronic device 200 according to the 14th example may include a pinion gear 362 configured to rotate in conjunction with the driving of the motor 610, and a rack gear 363 configured to move in the first direction 261 or 262 through a passage formed in the wall structure 560 in conjunction with the rotation of the pinion gear 362.

In a 15th example, the electronic device 200 according to any one of the 1st example to the 14th example may include a motor 610 bracket 630, supporting the motor 610, coupled to a supporting plate 510 of the second housing part 521. The second housing part 521 according to the 15th example may be configured to slide in a first direction 261 or 262 with respect to the first housing part 210. The motor 610 bracket 630 according to the 15th example may include a first portion and a second portion divided with respect to a rotational axis A1 of the motor 610. The electronic device 200 according to the 15th example may include a first screw 1081 passing through the first portion of the motor 610 bracket 630 and fastened to the supporting plate 510 of the second housing part 521, and a second screw 1082 and a third screw 1083 passing through the second portion of the motor 610 bracket 630 and fastened to the supporting plate 510 of the second housing part 521, respectively. The second screw 1082 and the third screw 1083 according to the 15th example may be arranged in a direction parallel to the rotational axis A1 of the motor 610.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (200) comprising:
a first housing part (210);
a second housing part (521), slidably coupled with respect to the first housing part (210), including a first side (530A) and a second side (530B) opposite to the first side (530A); and
a motor (610), disposed in the first housing part (210), positioned between the first side (530A) and the second side (530B), and configured to slide the second housing part (521) with respect to the first housing part (210),
wherein the second housing part (521) includes a wall structure (560), and
wherein the wall structure (560) includes:
a first portion disposed around the motor (610), and
a second portion, extending from the first portion, connected to at least one of the first side (530A) and the second side (530B).

2. The electronic device (200) of claim 1,
wherein the second portion of the wall structure (560) is connected to both the first side (530A) and the second side (530B).

3. The electronic device (200) of claim 1 or 2,
wherein the second portion of the wall structure (560) is integrally formed with the first portion of the wall structure (560).

4. The electronic device (200) of claim 1,
wherein the second portion of the wall structure (560) is connected to the first side (530A) of the first side (530A) and the second side (530B).

5. The electronic device (200) of claim 4,
wherein the second portion of the wall structure (560) extends from a part of the first portion of the wall structure (560) to the first side (530A), and
wherein the wall structure (560) includes a third portion extending from another part of the first portion of the wall structure (560) to the second side (530B).

6. The electronic device (200) of claim 5,
wherein the first portion of the wall structure (560) is integrally formed with the second portion of the wall structure (560).

7. The electronic device (200) of claim 5 or 6,
wherein the first portion of the wall structure (560) is integrally formed with the third portion of the wall structure (560).

8. The electronic device (200) of any one of claims 1 to 7,
wherein the second housing part (521) is configured to be slidable in a first direction (261; 262) with respect to the first housing part (210), and
wherein the first side (530A) and the second side (530B) are substantially parallel to the first direction (261; 262).

9. The electronic device (200) of any one of claims 1 to 7,
wherein the second housing part (521) is configured to be slidable in a first direction (261; 262) with respect to the first housing part (210), and
wherein the first portion of the wall structure (560) is substantially perpendicular to the first direction (261; 262) and overlaps the motor (610) in the first direction (261; 262).

10. The electronic device (200) of any one of claims 1 to 9,
wherein the wall structure (560) is configured to mitigate vibration of the second housing part (521) caused by the driving of the motor (610).

11. The electronic device (200) of any one of claims 1 to 10, comprising:
a printed circuit board (PCB); and
a flexible printed circuit board (FPCB) electrically connecting the motor (610) to the PCB,
wherein the wall structure (560) includes a first wall (561) and a second wall (562-1) spaced apart from the first wall (561), and
wherein the FPCB is disposed between the first wall (561) and the second wall (562-1).

12. The electronic device (200) of claim 11,
wherein the wall structure (560) includes a third wall (562-2) extending from the first wall (561) to the second wall (562-1) below the PCB.

13. The electronic device (200) of claim 12,
wherein the first wall (561), the second wall (562-1), and the third wall (562-2) are included in the first portion of the wall structure (560).

14. The electronic device (200) of any one of claims 1 to 13,
wherein the second housing part (521) is configured to slide in a first direction (261; 262) with respect to the first housing part (210), and
wherein the electronic device (200) comprises:
a pinion gear (362) configured to rotate in conjunction with the driving of the motor (610); and
a rack gear (363) configured to move in the first direction (261; 262) through a passage formed in the wall structure (560) in conjunction with the rotation of the pinion gear (362).

15. The electronic device (200) of any one of claims 1 to 14, comprising:
a motor (610) bracket (630), supporting the motor (610), coupled to a supporting plate of the second housing part (521),
wherein the second housing part (521) is configured to slide in a first direction (261; 262) with respect to the first housing part (210),
wherein the motor (610) bracket (630) includes a first portion and a second portion divided with respect to a rotational axis (A1) of the motor (610),
wherein the electronic device (200) comprises:
a first screw (1081) passing through the first portion of the motor (610) bracket (630) and fastened to the supporting plate of the second housing part (521); and
a second screw (1082) and a third screw (1083) passing through the second portion of the motor (610) bracket (630) and fastened to the supporting plate of the second housing part (521), respectively, and
wherein the second screw (1082) and the third screw (1083) are arranged in a direction parallel to the rotational axis (A1) of the motor (610).
